# EUROPEAN PATENT APPLICATION

(11) **EP 4 354 730 A1**
(43) Date of publication of application: **17.04.2024**
(21) Application number: 22937668.6
(22) Date of filing: 27.09.2022
(51) Int. Cl.: H03H 9/17

(54) **BULK ACOUSTIC RESONATOR, RESONATOR ASSEMBLY, FILTER, AND ELECTRONIC DEVICE**

(30) Priority: 26.08.2022 CN 202211034164
(71) Applicant: JWL (Zhejiang) Semiconductor Co., Ltd., Huzhou, Zhejiang 313000 (CN)
(72) Inventor: LI, Linping, Zhejiang 313000 (CN)
(74) Representative: Kolster Oy Ab
(86) International application number: PCT/CN2022/121570
(87) International publication number: WO 2024/040678

(57) **Abstract**

A bulk acoustic resonator, a method for manufacturing the bulk acoustic resonator, a filter and an electronic device are provided. The bulk acoustic resonator includes a substrate and an acoustic reflection structure, a bottom electrode, a piezoelectric layer, and a top electrode that are sequentially arranged in a direction away from the substrate. A surface of the bottom electrode away from the substrate is provided with a first recess. When the piezoelectric layer is formed on a side of the bottom electrode away from the substrate, a morphology of the first recess is transferred to a surface of the piezoelectric layer away from the substrate, to form a second recess on the surface of the piezoelectric layer away from the substrate. The piezoelectric layer has a constant thickness, which indicates that the piezoelectric layer is not subjected to etching and other physical damage, so that the local stress distribution of the piezoelectric layer close to the second recess is not damaged, thereby improving the performance and yield of the bulk acoustic resonator. Moreover, the first recess and the second recess are located close to an edge of the effective resonance region, which can suppress transverse wave resonance, reduce transverse wave leakage, and improve the quality factor of the bulk acoustic resonator.

## Description

This application claims the priority to Chinese Patent Application No. 202211034164.7, titled "BULK ACOUSTIC RESONATOR, RESONATOR ASSEMBLY, FILTER, AND ELECTRONIC DEVICE", filed on August 26, 2022 with the China National Intellectual Property Administration, which is incorporated herein by reference in its entirety.

### FIELD

The present disclosure relates to technical field of semiconductors, and in particular to a bulk acoustic resonator, a resonator assembly, a filter and an electronic device.

### BACKGROUND

With the increasingly crowded of electromagnetic spectrums, the increasing frequency bands and functions of wireless communication devices, and the rapid growth of electromagnetic spectrums of wireless communication from 500MHz to more than 5GHz, radio frequency front-end modules with high performance, low cost, low power consumption and small size are increasingly required. As a radio frequency front-end module, the filter plays an important role in improving the transmission and reception of signals. A filter is formed by multiple thin film bulk acoustic resonators (Fbars) connected to each other through a topological network structure, and meets high requirements of a radio frequency front-end module due to features of small size, strong integration ability, a high quality factor at high frequency operation, and strong power tolerance. Therefore, the manufacturing of high-performance bulk acoustic resonators becomes one of the current research hotspots.

The bulk acoustic resonator in a sandwiched structure includes a bottom electrode, a top electrode, and a piezoelectric layer arranged between the top electrode and the bottom electrode. When an electric field is applied to the bottom electrode and the top electrode, the piezoelectric layer converts the electrical energy into the mechanical energy by using Inverse Piezoelectric Effect. The mechanical energy exists in a form of sound waves. The mechanical energy is converted into the electrical energy by using Piezoelectric Effect to be outputted. The top electrode is in contact with the air, so that the sound waves are totally reflected at a boundary between the top electrode and the air. In addition, an acoustic reflection component is arranged below the bottom electrode, to totally reflect the sound waves, thus suppressing energy leakage.

At least one side of a top electrode of the conventional bulk acoustic resonator is required to extend to an outer edge of the acoustic reflection component to connect to another resonator, pad, or other electrical component. However, in such connection manner, the top electrode may be overlapped with the bottom electrode on a region outside the acoustic reflection component. A substrate is arranged below the overlapping region, and the sound waves cannot be totally reflected, resulting in parasitic oscillation that may appear as a stray signal in an output signal, and deterioration in the performance of the bulk acoustic resonator.

In addition, the piezoelectric layer may have a growth defect during a growth process. For example, many growth defects are generated at a location where the morphology of the piezoelectric layer changes due to lattice mismatch between materials, resulting in the loss of acoustic energy in the resonator and a decrease in the Q factor. Further, a transverse sound wave is generated during the operation of the resonator, which also lead to a decrease in the Q factor.

Therefore, how to reduce the acoustic energy loss of the bulk acoustic resonator and improve the Q factor is a problem concerned by people.

### SUMMARY

In order to solve the above technical problem, a bulk acoustic resonator, a resonator assembly, a filter and an electronic device are provided according to embodiments of the present disclosure, to reduce the acoustic energy loss of the bulk acoustic resonator and improve the Q factor.

In order to achieve the above objectives, a bulk acoustic resonator is provided according to a first aspect of the present disclosure. The bulk acoustic resonator includes a first electrode, a second electrode and a piezoelectric layer arranged between the first electrode and the second electrode. An acoustic reflection component is arranged on a side of the first electrode away from the piezoelectric layer, and an overlapping part of the acoustic reflection component, the first electrode, the piezoelectric layer, and the second electrode is defined as an effective resonance region. The second electrode includes a second electrode connection part in addition to a part of the second electrode within the effective resonance region. The piezoelectric layer extends beyond an end of the first electrode, a thickness of the piezoelectric layer is constant, a first gap is formed between the second electrode connection part and the piezoelectric layer, and in a direction from the first electrode to the second electrode, an upper surface of the first gap is not higher than an upper surface of a part of the piezoelectric layer within the effective resonance region.

In an embodiment, a side of the first gap is located inside the acoustic reflection component, or coincides with an edge of the acoustic reflection component, and another side of the first gap is located outside the end of the first electrode.

In an embodiment, the first gap is partially overlapped with the first electrode.

In an embodiment, the piezoelectric layer includes a defect region with a growth defect, and the first gap at least partially covers the defect region.

In an embodiment, the end of the first electrode extends beyond an edge of the acoustic reflection component.

In an embodiment, the first electrode includes a first thinning region, a thickness of the first thinning region is less than a thickness of a part of the first electrode within the effective resonance region, where the piezoelectric layer directly covers the first thinning region, to form the first gap between the piezoelectric layer and the second electrode connection part, and a side of the first thinning region is located inside the acoustic reflection component.

In an embodiment, another side of the first thinning region coincides with the end of the first electrode, or a distance between another side of the first thinning region with the end of the first electrode is provided.

In an embodiment, a contact surface between the first thinning region and the piezoelectric layer is step-shaped, arc-shaped or inclined-shaped.

In an embodiment, the first electrode includes a first metal electrode and a second metal electrode that are arranged to be stacked, the second metal electrode is located on a side of the first metal electrode close to the piezoelectric layer, and ends of the second metal electrode are shrunk in relative to ends of the first metal electrode to form a first thinning region.

In an embodiment, the bulk acoustic resonator further includes a substrate. The acoustic reflection component is embedded into the substrate, or is arranged on a surface of the substrate.

In an embodiment, the acoustic reflection component is located on the surface of the substrate, and the first electrode protrudes upwards on the surface of the substrate, where the acoustic reflection component is located between a protruding upwards part of the first electrode and the surface of the substrate, and the piezoelectric layer directly covers the first electrode, to form the first gap between the piezoelectric layer and the second electrode connection part.

In an embodiment, in a direction from the first electrode to the second electrode, an upper surface of the second electrode connection part is not higher than an upper surface of a part of the second electrode within the effective resonance region.

In an embodiment, the upper surface of the second electrode connection part is flush with the upper surface of the part of the second electrode within the effective resonance region.

In an embodiment, the second electrode connection part is connected to the part of the second electrode within the effective resonance region through a recess part, a part of the recess part connected to the part of the second electrode within the effective resonance region directly contacts with the piezoelectric layer.

In an embodiment, the recess part is V-shaped or U-shaped.

In an embodiment, in a direction from the first electrode to the second electrode, the upper surface of the second electrode connection part is lower than the upper surface of the part of the second electrode within the effective resonance region, and the second electrode connection part is connected to the part of the second electrode within the effective resonance region through an inclined part.

In an embodiment, the inclined part directly contacts with the piezoelectric layer; or the part of the second electrode within the effective resonance region extends horizontally for a distance to connect to the inclined part, where the inclined part does not contact with the piezoelectric layer.

In an embodiment, a part of the second electrode other than the second electrode connection part extends away from the effective resonance region to form an extension part of the second electrode, a second gap is formed between the second electrode extension part and the piezoelectric layer, and in the direction from the first electrode to the second electrode, an upper surface of the second gap is not higher than an upper surface of a part of the piezoelectric layer within the effective resonance region.

In an embodiment, the first electrode further includes a second thinning region, a thickness of the second thinning region is less than a thickness of a part of a first electrode within the effective resonance region, where the piezoelectric layer directly covers the second thinning region, to form the second gap between the piezoelectric layer and the second electrode extension part.

In an embodiment, the acoustic reflection component is a cavity or a Bragg reflector.

A resonator assembly is further provided according to a second aspect of the present disclosure. The resonator assembly includes a first resonator, an electrical component and a connection structure. The first resonator is any one bulk acoustic resonator described above. Two ends of the connection structure are connected to a second electrode connection part in the first resonator and the electrical component, respectively.

In an embodiment, in the direction from the first electrode to the second electrode, an upper surface of the connection structure is not higher than an upper surface of a part of the second electrode within the effective resonance region in the first resonator.

In an embodiment, in the direction from the first electrode to the second electrode, the upper surface of the connection structure is flush with the upper surface of the part of the second electrode within the effective resonance region in the first resonator, and a third gap is formed between the connection structure and the piezoelectric layer.

In an embodiment, in the direction from the first electrode to the second electrode, the upper surface of the connection structure is lower than the upper surface of the part of the second electrode within the effective resonance region in the first resonator, and a third gap is formed between the connection structure and the piezoelectric layer, or the connection structure directly contacts with the piezoelectric layer.

In an embodiment, a side the second electrode connection part close to the connection structure includes at least one concave-convex structure, and the connection structure is connected to at least one of the second electrode connection part in the first resonator and the electrical component through the at least one concave-convex structure.

In an embodiment, the electrical component includes a bulk acoustic resonator, a capacitor, an inductor, or a pad.

In an embodiment, the second electrode of the first resonator is connected to the electrical component through the second electrode connection part, the connection structure, and a connection member, the piezoelectric layer is provided with a through hole, the connection member is arranged in the through hole and connected to the electrical component, in the direction from the first electrode to the second electrode, the connection member extends from the through hole to an upper surface of the piezoelectric layer.

In an embodiment, an end of the connection member arranged on the upper surface of the piezoelectric layer is lifted upwards to form a lifting part, and a fourth gap is formed between the lifting part and the piezoelectric layer.

A filter is further provided according to a third aspect of the present disclosure. The filter includes any one bulk acoustic resonator described above, or any one resonator assembly described above.

An electronic device is further provided according to a fourth aspect of the present disclosure. The electronic device includes any one bulk acoustic resonator described above, or any one resonator assembly described above.

Compared with the conventional technology, the above technical solutions at least have the following advantages.

The bulk acoustic resonator according to the present disclosure includes a first electrode, a second electrode and a piezoelectric layer arranged between the first electrode and the second electrode. An acoustic reflection component is arranged on a side of the first electrode away from the piezoelectric layer. An overlapping part of the acoustic reflection component, the first electrode, the piezoelectric layer, and the second electrode is defined as an effective resonance region. The second electrode includes a second electrode connection part in addition to a part of the second electrode within the effective resonance region. The piezoelectric layer extends beyond an end of the first electrode. A first gap is formed between the second electrode connection part and the piezoelectric layer, so that the second electrode connection part is separated from the piezoelectric layer, avoiding the parasitic oscillation caused by overlapping of the second electrode connection part, the first electrode and the piezoelectric layer on a region outside the acoustic reflection component.

Moreover, compared with the conventional technology where the top electrode connection part adopts an air bridge structure protruding upwards, in the bulk acoustic resonator according to the embodiment of the present disclosure, in the direction from the first electrode to the second electrode, the upper surface of the first gap is not higher than the upper surface of the part of the piezoelectric layer within the effective resonance region, that is, the second electrode connection part does not protrude upwards into a bridge structure, but extends horizontally or extends towards a side of the piezoelectric layer, which has higher mechanical stability than the bridge structure protruding upwards, and is not easily collapsed and fractured. Moreover, the second electrode connection part that extends horizontally or extends towards the side of the piezoelectric layer provides a transverse stretching effect for the central region of the resonator, thereby preventing the center region of the resonator from being collapsed or deformed.

In the bulk acoustic resonator according to the embodiments of the present disclosure, the piezoelectric layer has the constant thickness, that is, the piezoelectric layer is not subjected to etching and other physical damage. A film layer below the piezoelectric layer is thinned or a slope morphology is formed in another way. The piezoelectric layer is deposited on the slope morphology, the slope morphology is directly transferred to the upper surface of the piezoelectric layer, so that the first gap is formed between the second electrode connection part and the piezoelectric layer. Therefore, a local stress of the piezoelectric layer is not damaged, the piezoelectric layer has the constant thickness in a horizontal direction on the entire wafer, a stress fluctuation is small and distribution of the stress is uniform, thereby improving the yield of the resonator and an effective electromechanical coupling coefficient of the resonator, further ensuring the mechanical strength and reliability of the resonator. Moreover, the growth of the piezoelectric layer by means of morphology transfer is simple and easy to implement.

The other objectives and the advantages of the present disclosure are described in detail in the following embodiments in conjunction with the drawings.

### BRIEF DESCRIPTION OF THE DRAWINGS

In order to more clearly illustrate technical solutions in embodiments of the present disclosure or in the conventional technology, the drawings to be used in the description of the embodiments or the conventional technology are briefly described below. Apparently, the drawings in the following description show only some embodiments of the present disclosure, and other drawings may be obtained by those skilled in the art from the drawings without any creative work.
Figure 1 is a schematic structural diagram of a bulk acoustic resonator with a bottom electrode partially covering an acoustic reflection component according to the conventional technology;
Figure 2 is a schematic structural diagram of a bulk acoustic resonator with a bottom electrode completely covering an acoustic reflection component according to the conventional technology;
Figure 3 is a schematic structural diagram of a bulk acoustic resonator with an air bridge serving as a top electrode connection part according to the conventional technology;
Figure 4 is a schematic diagram showing that a central region of a resonator with a large area is collapsed and deformed according to the conventional technology;
Figures 5, 5-1, 5-2, and 5-3 are schematic structural diagrams of a bulk acoustic resonator and a resonator assembly according to different embodiments of the present disclosure;
Figure 5-4 is a schematic structural diagram of a bulk acoustic resonator according to an embodiment of the present disclosure;
Figures 5-5, 5-6, 5-7, 5-8, 5-9, and 5-10 are schematic structural diagrams of a bulk acoustic resonator and a resonator assembly according to different embodiments of the present disclosure;
Figure 6 is a schematic enlarged view of a bulk acoustic resonator shown in Figure 5;
Figure 6-1 is a schematic enlarged view of a first thinning region 11 shown in Figure 6;
Figures 7 and 7-1 are schematic structural diagrams of a bulk acoustic resonator and a resonator assembly according to different embodiments of the present disclosure;
Figures 8, 8-1, 8-2, and 8-3 are schematic structural diagrams of a bulk acoustic resonator and a resonator assembly according to different embodiments of the present disclosure;
Figures 9, 9-1, 9-2, 9-3 and 9-4 are schematic structural diagrams of a bulk acoustic resonator and a resonator assembly according to different embodiments of the present disclosure;
Figure 10 is a schematic diagram of a comparison of a photolithography process and an etching process under an ideal condition and an actual condition in a case that an air bridge serving as a top electrode connection part according to the conventional technology;
Figures 11 to 13 are schematic structural diagrams of a bulk acoustic resonator and a resonator assembly according to different embodiments of the present disclosure;
Figure 14 is a schematic diagram of a Smith circle of a bulk acoustic resonator shown in Figure 5 according to the present disclosure and a conventional bulk acoustic resonator in a sandwiched structure; and
Figure 15 is a schematic diagram of impedance variation with frequency of a bulk acoustic resonator shown in Figure 5 according to the present disclosure and a conventional bulk acoustic resonator in a sandwiched structure.

### DETAILED DESCRIPTION

Technical solutions of embodiments of the present disclosure are described below clearly and completely in conjunction with the drawings of the embodiments of the present disclosure. Apparently, the embodiments described below are only some embodiments of the present disclosure, rather than all the embodiments. All other embodiments obtained by those skilled in the art based on the embodiments in the present disclosure without any creative effort fall within the protection scope of the present disclosure.

Many details are set forth in the following description to facilitate a full understanding of the present disclosure. However, the present disclosure may be implemented in other manners different from those described herein. Those skilled in the art may make similar promotion without departing from connotation of the present disclosure. Therefore, the present disclosure is not limited by the embodiments disclosed below.

The present disclosure is described in detail in conjunction with the drawings. To facilitate description in describing embodiments of the present disclosure in detail, a sectional view showing a structure of a device is not partially enlarged on a general scale. The schematic diagram is merely exemplary, and the protection scope of present disclosure should not be limited thereto. In addition, the three-dimensional spatial dimensions of length, width and depth should be included in practical manufacture.

The term "overlap" in the present disclosure refers to an overlap of a film layer arranged on a substrate in a projection perpendicular to the substrate.

The term "first electrode" in the present disclosure is defined as an electrode close to a growth substrate, and "second electrode" is defined as an electrode away from the growth substrate.

The term "upper surface" of a gap in the present disclosure refers to a surface opposite to a bottom surface for a shape of the entire gap, which includes not only a surface arranged above a horizontal plane, but also a surface inclined to the horizontal plane.

As described in the BACKGROUND part, how to reduce the acoustic energy loss of the bulk acoustic resonator, improve the Q factor, and reduce parasitic oscillation caused by overlapping of the top electrode and the bottom electrode on a region outside the acoustic reflection component is a problem concerned by people.

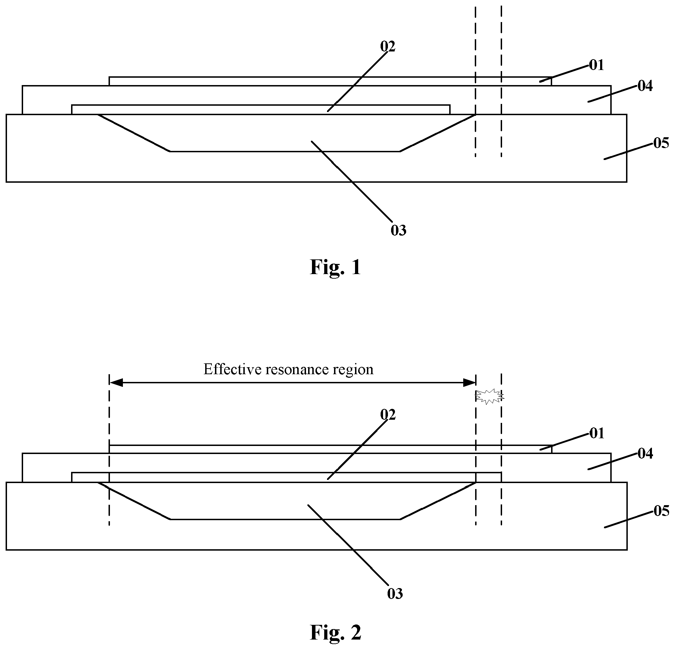

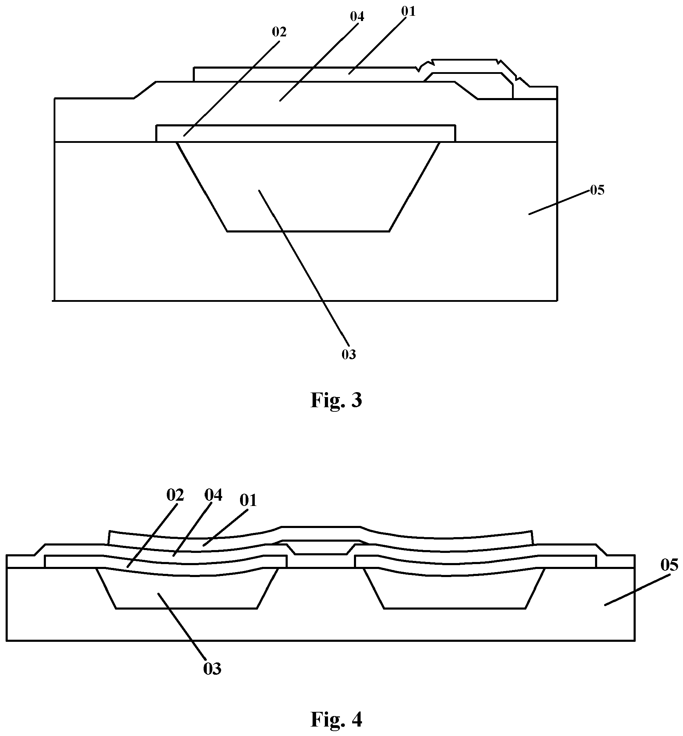

It is found that in order to avoid the overlapping the top electrode 01 and the bottom electrode 02 of the bulk acoustic resonator on the region outside the acoustic reflection component 03, the bottom electrode 02 partially covers the acoustic reflection component 03, thereby reducing or suppressing the parasitic oscillation. As shown in Figure 1, 04 represents a piezoelectric layer and 05 represents a substrate. It can be seen that an end of the bottom electrode 02 is arranged on an inner edge of the acoustic reflection component 03, and has a distance from the edge of the acoustic reflection component 03. The top electrode 01 may extend outward above the end of the bottom electrode 02 to connect to another electrical component, so that the top electrode 01 is not overlapped with the bottom electrode 02 and no parasitic oscillation is generated on the region outside the acoustic reflection component 03. As shown in Figure 1, no parasitic oscillation is generated in a region between two dashed lines. However, it may be understood that the mechanical stability of such structure is poor, which has a significant impact on deposition processes of the bottom electrode 02 and the piezoelectric layer 04. Especially in a case that the acoustic reflection component is a cavity, after the cavity is released, a bottom of the piezoelectric layer 04 is easily significantly deformed due to lack of the support from the bottom electrode 02, resulting in inconsistent performance of different resonators. Therefore, the structure has poor yield, and is rarely adopted from the perspective of the mass production process.

In a case that the bottom electrode 02 completely covers the acoustic reflection component 03 and the acoustic reflection component 03 is a cavity, as shown in Figure 2, the bottom electrode 02 extends beyond the edge of the cavity 03 and is partially overlapped with the substrate 05. The bottom electrode 02 is supported by the substrate 05, which can ensure the mechanical stability of the structure of the resonator and the process stability of depositing the bottom electrode 02 and the piezoelectric layer 04. However, in a case that a side of the top electrode 01 extends outward to connect to another electrical component, the top electrode 01 is overlapped with the bottom electrode 02 on the region outside the acoustic reflection component 03. As shown in Figure 2, the region is between the two dashed lines and outside an effective resonance region. Parasitic oscillation is generated in the overlapping region, resulting in a stray signal appearing in an output signal and deterioration in the performance of the resonator. Therefore, many researchers have been studying how to reduce parasitic oscillation while the bottom electrode completely covers the acoustic reflection component, in order to achieve a balance between the performance and reliability of the resonator.

In order to reduce or eliminate the parasitic oscillation, it is proposed that a part (i.e. a top electrode connection part) of the top electrode 01 that is connected to another electrical component is manufactured into a bridge structure protruding upwards. As shown in Figure 3, 01 represents the top electrode, 02 represents the bottom electrode, 03 represents the acoustic reflection component, 04 represents the piezoelectric layer, and 05 represents the substrate. It can be seen that the bridge structure is separated from the piezoelectric layer 04 by air, that is, an air bridge is formed, so that the top electrode connection part is separated from the piezoelectric layer 04, avoiding the parasitic oscillation caused by overlapping of the top electrode connection part and the bottom electrode 02 on the region outside the acoustic reflection component 03.

However, it is further found that the air bridge protruding upwards serving as the top electrode connection part has the following problems.
(1) Collapse and fracture are prone to occur in a high-frequency application, resulting in low mechanical stability.
   An electrode of a high-frequency resonator has a relatively small thickness. For example, the electrode has a thickness of 150nm at a frequency of 3.5GHz, a thickness of only 90nm at a frequency of 3.5GHz, and a thickness of only 50nm at a frequency of 7GHz. Moreover, during deposition of the electrode, a material per unit volume is unchanged. A length of an inclined side of the bridge structure protruding upwards increases, and thus the deposited material at the inclined side becomes thinner. The electrode is normally made of a material with high hardness, such as Mo, Ru, W, or other metal. In a case that the top electrode is particularly thin and protrudes, the protruding part is easily cracked during deposition. Especially, the metal material is difficult to be deposited on a horizontal part and a corner of the protruding part of the top electrode, which causes that the corner is easily cracked. Therefore, the resonator, when being stretched by external forces, such as thermal expansion, bending, dropping and other situation in an environment, is easily collapsed and fracture.
(2) In a case that the resonator has a large area, a central region of the resonator is easily collapsed and deformed.

As shown in Figure 4, 01 represents the top electrode, 02 represents the bottom electrode, 03 represents the acoustic reflection component, 04 represents the piezoelectric layer, and 05 represents the substrate. It can be seen that in a case that the resonator has the large area, the central region of the resonator is easily collapsed and deformed. In a case that the central region of the resonator is collapsed and deformed, two sides of the protruding air bridge are stretched, causing a height of the protruding air bridge to decrease. As a result, the protruding air bridge prevents the central region of the resonator from being subjected to a tensile force, which accelerates the collapse and deformation of the central region of the resonator.

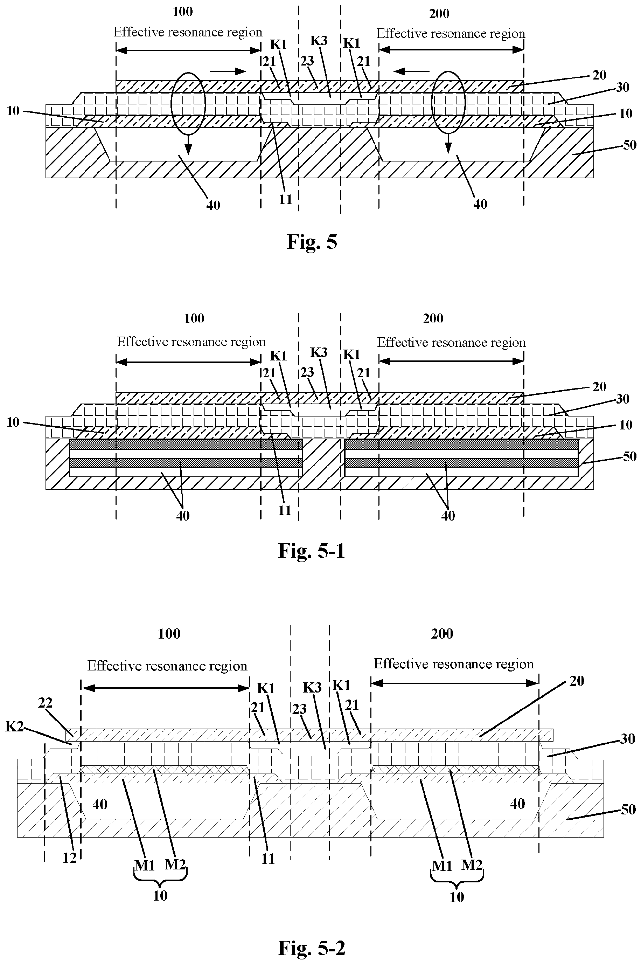

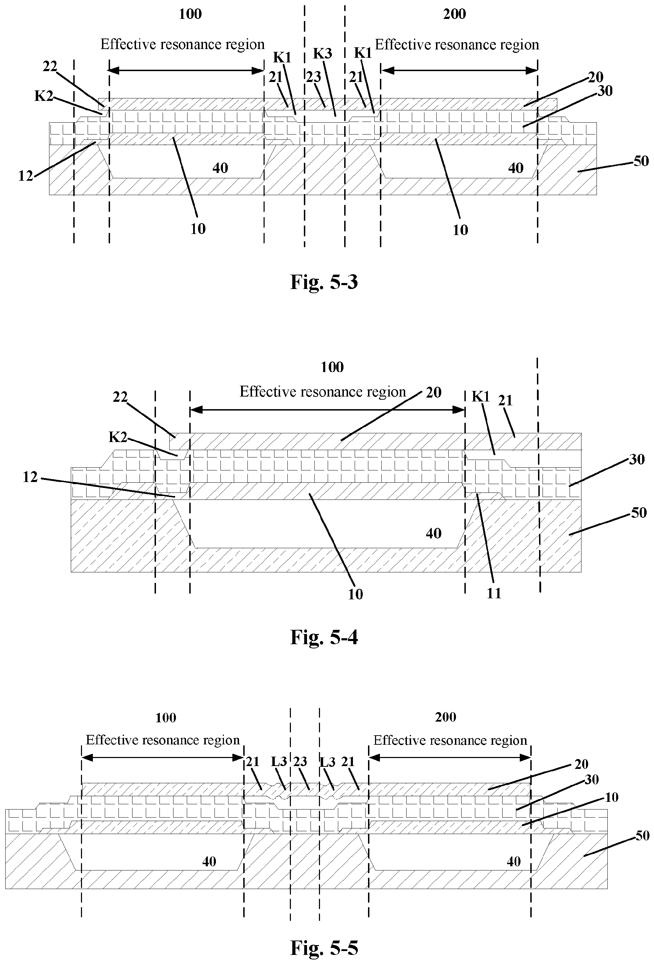

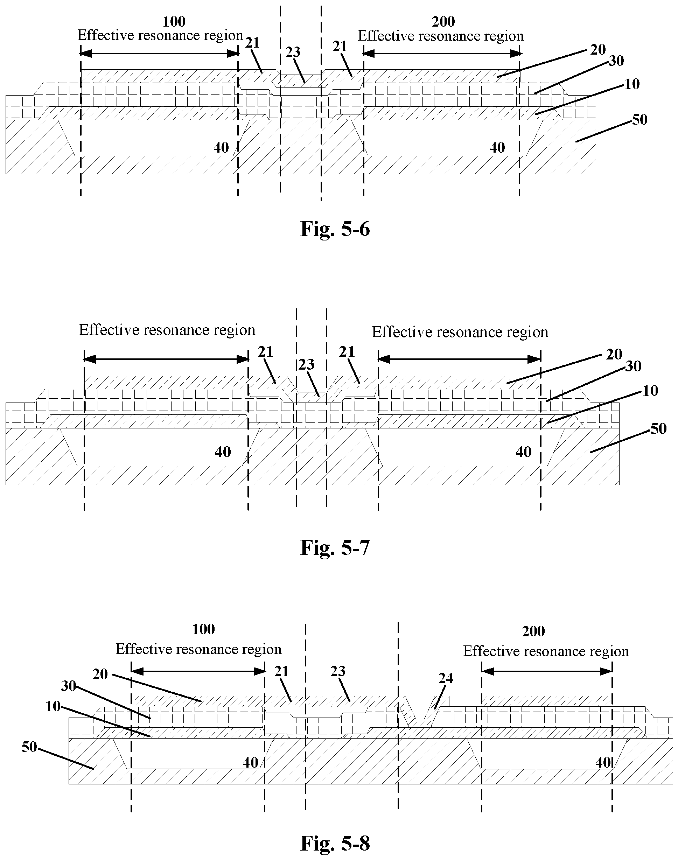

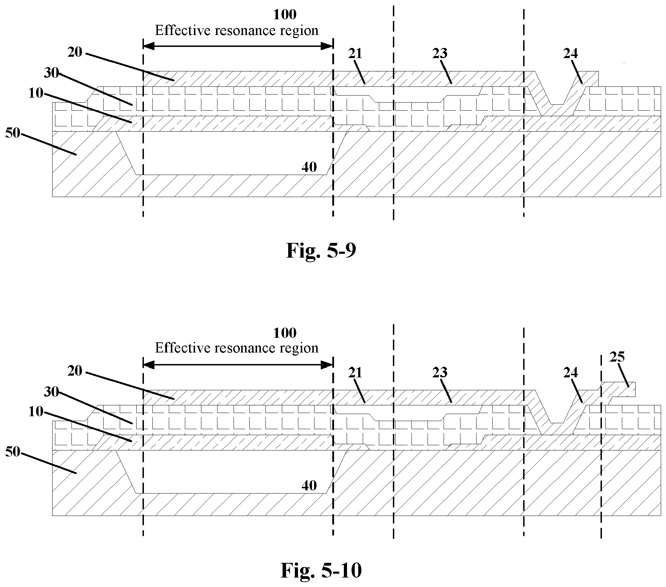

Based on the above research, a bulk acoustic resonator 100 is provided according to an embodiment of the present disclosure. As shown in Figures 5, 7, 8, and 9, the bulk acoustic resonator 100 includes a first electrode 10, a second electrode 20, and a piezoelectric layer 30 arranged between the first electrode 10 and the second electrode 20. An acoustic reflection component 40 is arranged on a side of the first electrode 10 away from the piezoelectric layer 30. An overlapping part of the acoustic reflection component 40, the first electrode 10, the piezoelectric layer 30, and the second electrode 20 is defined as an effective resonance region. The second electrode 20 includes a second electrode connection part 21 in addition to a part of the second electrode located within the effective resonance region. The piezoelectric layer 30 extends beyond an end of the first electrode 10, and has a constant thickness. A first gap K1 is formed between the second electrode connection part 21 and the piezoelectric layer 30. In a direction from the first electrode 10 to the second electrode 20, an upper surface of the first gap K1 is not higher than an upper surface of a part of the piezoelectric layer 30 within the effective resonance region.

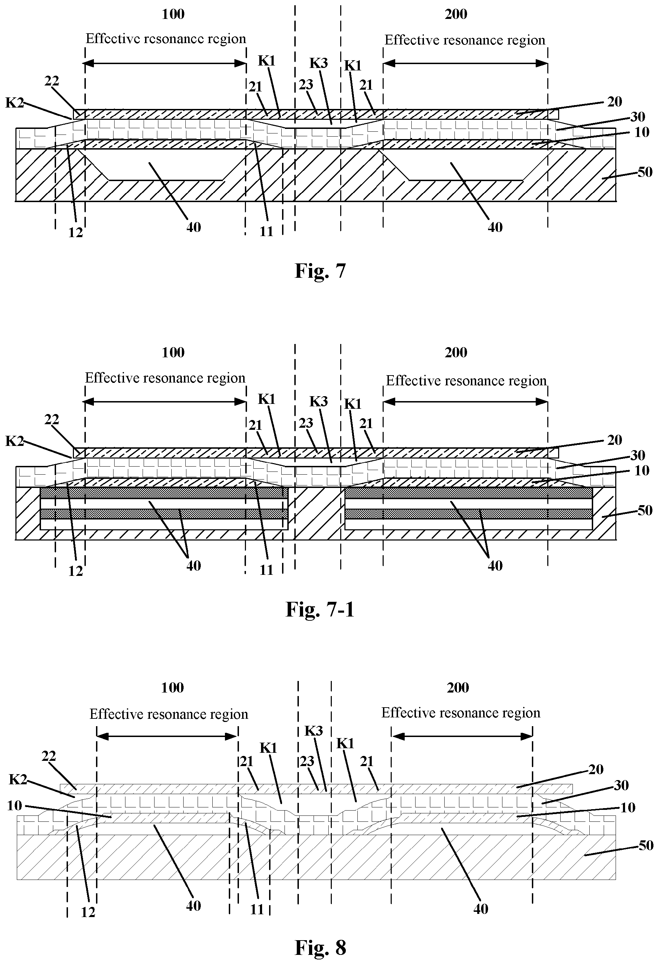

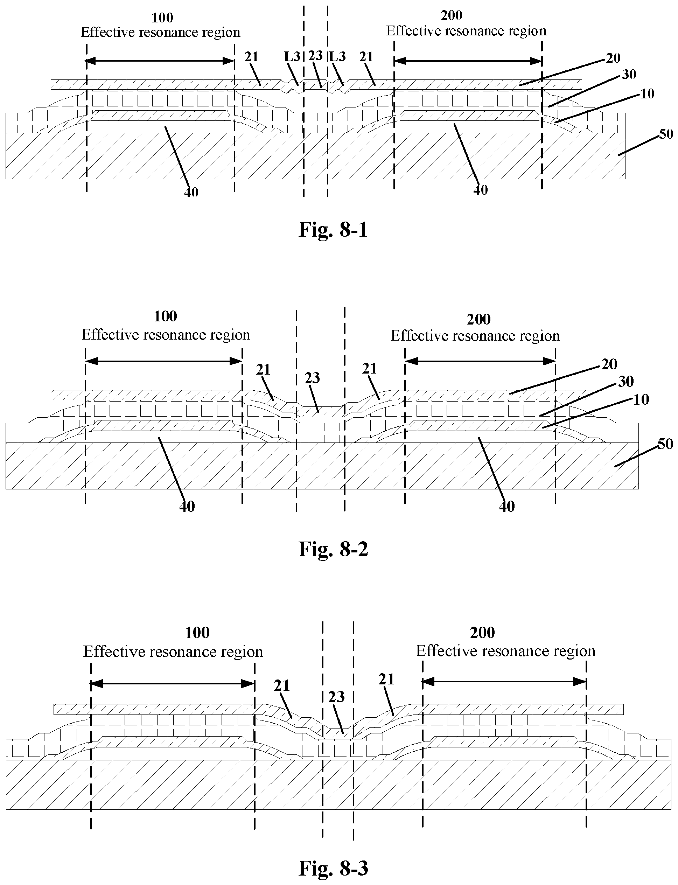

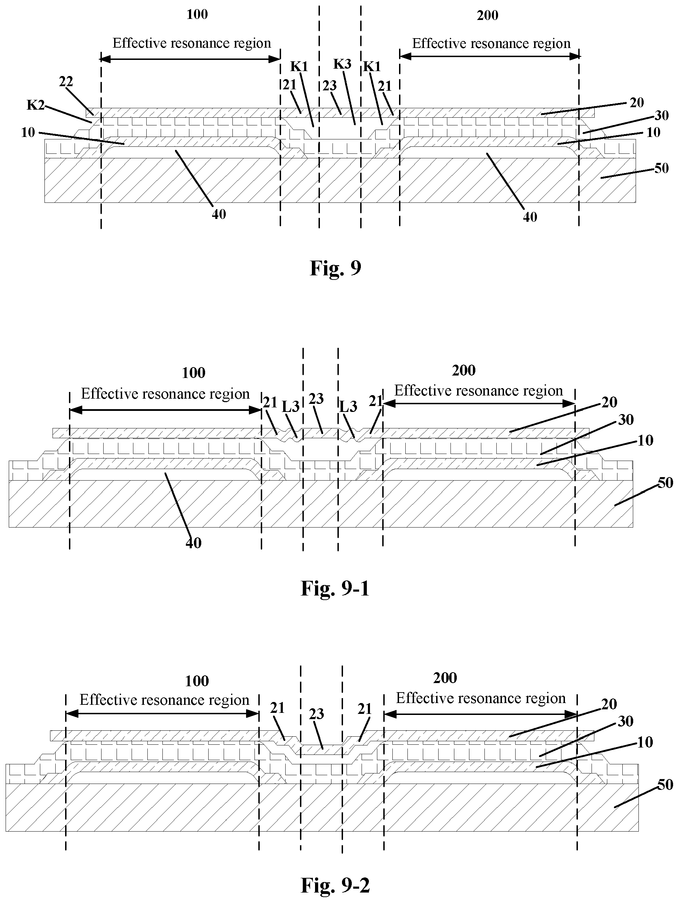

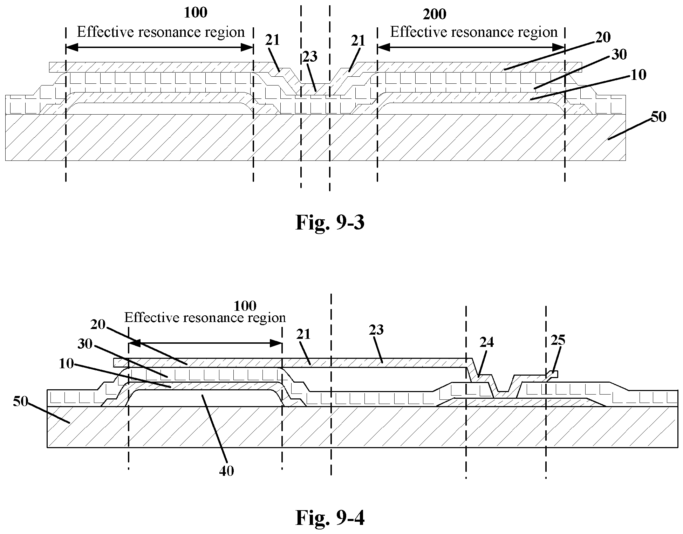

In an embodiment, the bulk acoustic resonator may further include a substrate 50, and the acoustic reflection component 40 may be embedded into the substrate 50 (as shown in Figures 5 and 7), or may be arranged on a surface of the substrate 50 (as shown in Figures 8 and 9). The substrate 50 may serve as a growth substrate, and the bulk acoustic resonator may be directly formed on the substrate 50 by depositing a film layer. Alternatively, the bulk acoustic resonator is deposited on another temporary substrate, and then may be bonded to the substrate 50 through a lift-off and bonding process.

In the bulk acoustic resonator according to the embodiment of the present disclosure, the second electrode connection part 21 is separated from the piezoelectric layer 30 by the first gap K1, avoiding the parasitic oscillation caused by the overlapping of the second electrode connection part 21, the first electrode 10, and the piezoelectric layer 30 on the region outside the acoustic reflection component 40.

Moreover, compared with the conventional technology where the top electrode connection part adopts an air bridge structure protruding upwards, that is, the upper surface of the gap between the top electrode connection part and the piezoelectric layer is higher than the upper surface of the part of the piezoelectric layer within the effective resonance region, in the bulk acoustic resonator according to the embodiment of the present disclosure, in the direction from the first electrode 10 to the second electrode 20, the upper surface of the first gap K1 is not higher than the upper surface of the part of the piezoelectric layer 30 within the effective resonance region, that is, the second electrode connection part 21 does not protrude upwards into a bridge structure, but extends horizontally or extends towards a side of the piezoelectric layer 30, which has higher mechanical stability than the bridge structure protruding upwards, and is not easily collapsed and fractured. Moreover, the second electrode connection part 21 that extends horizontally or extends towards the side of the piezoelectric layer 30 provides a transverse stretching effect for the central region of the resonator. For example, as shown by black arrows (representing a direction of force) in Figure 5, the horizontally extended second electrode connection part 21 provides the lateral stretching force on the central region of the resonator, thereby suppressing the collapse and deformation of the central region of the resonator.

It should be noted that in the bulk acoustic resonator according to the embodiment of the present disclosure, the first gap K1 between the second electrode connection part 21 and the piezoelectric layer 30 may be filled with air or a medium, such as a medium with low acoustic impedance, including carbon-doped SiOz, dielectric resin, Benzocyclobutene, and the like, depending on the situation.

It should further be noted that in order to form the first gap K1 between the piezoelectric layer 30 and the second electrode connection part 21, in the direction from the first electrode 10 to the second electrode 20, the upper surface of the first gap K1 is not higher than the upper surface of the part of the piezoelectric layer 30 within the effective resonance region, and an upper surface of a part of the piezoelectric layer 30 located below the second electrode connection part 21 is lower than the upper surface of the part of the piezoelectric layer 30 within the effective resonance region. The conventional process is that a part of the piezoelectric layer is removed by etching the piezoelectric layer 30. However, the etching may physically damage a local stress of the piezoelectric layer 30, and a local stress of the resonator is difficult to be controlled. In addition, a stress of the piezoelectric layer greatly changes with different positions on an entire wafer due to stress superposition and other factors during thin film deposition, resulting in non-uniform distribution of the stress, affecting the production yield of the resonator.

In the bulk acoustic resonator according to the embodiment of the present disclosure, the piezoelectric layer 30 has the constant thickness, that is, a thickness of the part of the piezoelectric layer 30 below the second electrode connection part 21 is equal to a thickness of the part of the piezoelectric layer 30 within the effective resonance region, which indicates that the piezoelectric layer 30 arranged outside the effective resonance region is not subjected to etching and other physical damage, and the upper surface of the part of the piezoelectric layer 30 below the second electrode connection part 21 is still lower than the upper surface of the part of the piezoelectric layer 30 within the effective resonance region. A film layer (such as the first electrode 10) below the piezoelectric layer 30 is thinned or a slope morphology is formed in another way, when the piezoelectric layer is deposited on the slope morphology, the slope morphology is directly transferred to the upper surface of the piezoelectric layer 30, so as to form the first gap K1 between the second electrode connection part 21 and the piezoelectric layer 30. It should be noted that the slope morphology herein is not limited to an inclined plane, a step surface, an arc-shaped surface, and the like.

It can be seen that in the bulk acoustic resonator according to the embodiment of the present disclosure, the thickness of the piezoelectric layer 30 is constant, and the first gap K1 is formed between the piezoelectric layer 30 and the second electrode connection part 21. In the direction from the first electrode 10 to the second electrode 20, the upper surface of the first gap K1 is not higher than the upper surface of the part of the piezoelectric layer 30 within the effective resonance region. The piezoelectric layer is not subjected to etching and other physical damage, so that the local stress of the piezoelectric layer is not damaged. The piezoelectric layer has the constant thickness in a horizontal direction on the entire wafer, a stress fluctuation is small and distribution of the stress is uniform, thereby improving the yield of the resonator and an effective electromechanical coupling coefficient of the resonator, further ensuring the mechanical strength and reliability of the resonator. Moreover, the growth of the piezoelectric layer by means of morphology transfer is simple and easy to implement.

In addition, the first gap K1 is formed between the piezoelectric layer 30 and the second electrode connection part 21, so that the part of the piezoelectric layer 30 below the second electrode connection part 21 is not damaged during etching the second electrode connection part 21, ensuring the integrity of the piezoelectric layer 30 on a surface of the entire resonator, avoiding a stress change to a part of the piezoelectric layer close to the effective resonance region, and greatly improving a power tolerance and the performance of anti-electrostatic breakdown of the resonator.

In an embodiment of the present disclosure, a side of the first gap K1 is located inside the acoustic reflection component 40 (as shown in Figures 5, 7, and 8), or coincides with an edge of the acoustic reflection component 40 (as shown in Figure 9), and another side of the first gap K1 is located outside the end of the first electrode 10 (as shown in Figure 5, and Figures 7 to 9). In such case, the first gap K1 is located outside an end of the effective resonance region and starts at the end. A part of the second electrode connection part 21 above the first gap K1 is separated from the piezoelectric layer 30 from a position inside of the acoustic reflection component 40 or from the edge of the acoustic reflection component 40 to a position outside the end of the first electrode 10. That is, the second electrode connection part 21 does not directly contact and is not overlapped with the piezoelectric layer 30 and the first electrode 10 from the position inside the acoustic reflection component 40 or from the edge of the acoustic reflection component 40 to the position outside the end of the first electrode 10. Since the another side of the first gap K1 is located outside the end of the first electrode 10, when the end of the first electrode 10 extends beyond the edge of the acoustic reflection component 40, the another side of the first gap K1 also extends beyond the edge of the acoustic reflection component 40. The first gap K1 can avoid the parasitic oscillation caused by direct contact and overlapping of the second electrode connection part 21, the piezoelectric layer 30, and the first electrode 10 on the region outside the acoustic reflection component 40. In a case that the end of the first electrode 10 is located inside the acoustic reflection component 40, the first gap K1 can make at least a part of a defect region of the piezoelectric layer 30 being outside the effective resonance region, thereby reducing the acoustic energy loss.

In an embodiment of the present disclosure, as shown in Figure 5, and Figures 7 to 9, the first gap K 1 is partially overlapped with the first electrode 10. In a case that the end of the first electrode 10 extends beyond the edge of the acoustic reflection component 40, that is, the end of the first electrode 10 is completely located outside the acoustic reflection component 40, or the end of the first electrode 10 is inclined and an inclined region crosses the edge of the acoustic reflection component 40. The first gap K1 at least covers a region of the first electrode 10 located outside the acoustic reflection component 40, so that the second electrode connection part 21 does not directly contact and overlap with the region of the first electrode 10, so as to avoid the parasitic oscillation. In a case that the end of the first electrode 10 is located inside the acoustic reflection component 40, for example, in a case that the end of the first electrode 10 is inclined, the first gap K1 is overlapped with the inclined region of the end of the first electrode 10, so that the effective resonance region does not include a part of the piezoelectric layer corresponding to the inclined region, and the piezoelectric layer above the inclined region may generate many growth defects, thus reducing the acoustic energy loss in the effective resonance region.

As described above, after the film layer (such as the first electrode 10) below the piezoelectric layer 30 is thinned or a slope morphology is formed on the film layer in another way, the piezoelectric layer 30 is deposited on the slope morphology, and the slope morphology is directly transferred to the upper surface of the piezoelectric layer 30, so that the first gap K1 is formed between the second electrode connection part 21 and the piezoelectric layer 30. However, in the actual processes, during forming the piezoelectric layer on the slope morphology, a defect region with a growth defect is formed on the piezoelectric layer due to a lattice difference between materials. The growth defect in the defect region is greater than the growth defect of the piezoelectric layer in the effective resonance region. If the defect region is located within the effective resonance region, the defect region may cause the acoustic energy loss. Therefore, the first gap K1 located outside the effective resonance region at least partially covers the defect region. Preferably, the first gap K1 completely covers the defect region, make the defect region is arranged outside the effective resonance region, thereby reducing the acoustic energy loss and improving the Q factor.

For example, the slope morphology is formed on the first electrode 10 for description below. Since a starting point of the slope morphology is close to a starting point of the first gap, the first gap K1 mostly covers the defect region of the piezoelectric layer 30 within the embodiment, so that the defect region covered by the first gap K1 is located outside the effective resonance region. Therefore, in the bulk acoustic resonator according to the embodiment, the acoustic energy loss in the effective resonance region is reduced, thereby improving the quality factor (Q factor) of the resonator.

In addition, compared with the part of the piezoelectric layer within the effective resonance region, a part of the piezoelectric layer 30 below the first gap K1 has a slope morphology, and undergoes a morphological change, and the morphological change may reflect a transverse sound wave generated within the effective resonance region, further reducing acoustic energy loss. In addition, the first gap K1 is located at the end of the effective resonance region, and provides different acoustic impedance interfaces for the effective resonance region of the resonator and a non-effective resonance region outside the effective resonance region, to further reflect the transverse sound wave, thereby reducing the acoustic energy loss.

In an embodiment of the present disclosure, as shown in Figure 5, Figures 7 to 9, the end of the first electrode 10 extends beyond the edge of the acoustic reflection component 40, that is, the first electrode 10 completely covers the acoustic reflection component 40, so that the first electrode 10 supports the piezoelectric layer, and the substrate 50 supports the first electrode 10, ensuring the mechanical stability of the structure and the process stability of depositing the electrode and the piezoelectric layer.

In an embodiment, the acoustic reflection component 40 may be a cavity or a Bragg reflector. In a case that the acoustic reflection component 40 is the cavity, the end of the first electrode 10 is required to extend beyond the edge of the acoustic reflection component 40, to ensure the mechanical stability of the structure. In a case that the acoustic reflection component 40 is the Bragg reflector, the end of the first electrode 10 may extend beyond the edge of the acoustic reflection component 40, or may do not extend beyond the edge of the acoustic reflection component 40. Figures 5-1 and 7-1 are schematic diagrams showing that the acoustic reflection component 40 is the Bragg reflector, and the end of the first electrode 10 does not extend beyond the edge of the acoustic reflection component 40.

It should be noted that in a case that the acoustic reflection component is the Bragg reflector, a solidly-mounted resonator (SMR) is formed, and the Bragg reflector prevents the sound wave from being emitted from the substrate of the resonator. The Bragg reflector is formed by alternating a low acoustic impedance layer and a high acoustic impedance layer that have different acoustic impedances. A thickness of the low acoustic impedance layer or a thickness of the high acoustic impedance layer is 1/4 of a wavelength of the sound wave in a material of the acoustic impedance layer. The high acoustic impedance layer is made of tungsten, and the low acoustic impedance layer is made of silicon oxide.

It can be seen from the foregoing descriptions that the film layer below the piezoelectric layer 30 is thinned, or the slope morphology is formed on the film layer in another way, so that the slope morphology is directly transferred to the upper surface of the piezoelectric layer 30 when the piezoelectric layer 30 is deposited on the slope morphology, and the first gap K1 is formed between the second electrode connection part 21 and the piezoelectric layer 30. The film layer below the piezoelectric layer 30 includes the first electrode 10. Therefore, the first electrode 10 may be thinned or the slope morphology may be formed on the first electrode 10 in another way, which is described in detailed in the following embodiments.

In an embodiment of the present disclosure, as shown in Figures 5, 7, and 8, the first electrode 10 includes a first thinning region 11. A thickness of the first thinning region 11 is less than a thickness of a part of the first electrode 10 within the effective resonance region, so that the piezoelectric layer 30 directly covers the first thinning region 11, to form the first gap K1 between the piezoelectric layer 30 and the second electrode connection part 21, and a side of the first thinning region 11 is located inside the acoustic reflection component 40.

In the embodiment, the first thinning region 11 in the first electrode 10, that is, the slope morphology is formed below the piezoelectric layer 30. Since the side of the first thinning region 11 is located inside the acoustic reflection component 40, the first thinning region 11 at least starts at a position inside the acoustic reflection component 40. Therefore, when the piezoelectric layer 30 is deposited on the first electrode 10, the slope morphology of the first thinning region 11 is directly transferred to the upper surface of the piezoelectric layer 30, so that a slope morphology is also formed on the upper surface of the piezoelectric layer 30. In addition, the slope morphology on the upper surface of the piezoelectric layer at least starts from the edge of the acoustic reflection component 40 or from the inner side of the acoustic reflection component 40, and thus the first gap K1 at least starts from the edge of the acoustic reflection component 40 or from the inner side of the acoustic reflection component 40, so that the second electrode connection part 21 is completely separated from the piezoelectric layer 30 by the first gap K1 on the region outside the acoustic reflection component 40, thereby reducing or suppressing the parasitic oscillations.

In the embodiment, a shape of a contact surface between the first thinning region 11 and the piezoelectric layer 30 is not limited. In an embodiment of the present disclosure, as shown in Figure 5, the contact surface between the first thinning region 11 and the piezoelectric layer 30 may be step-shaped.

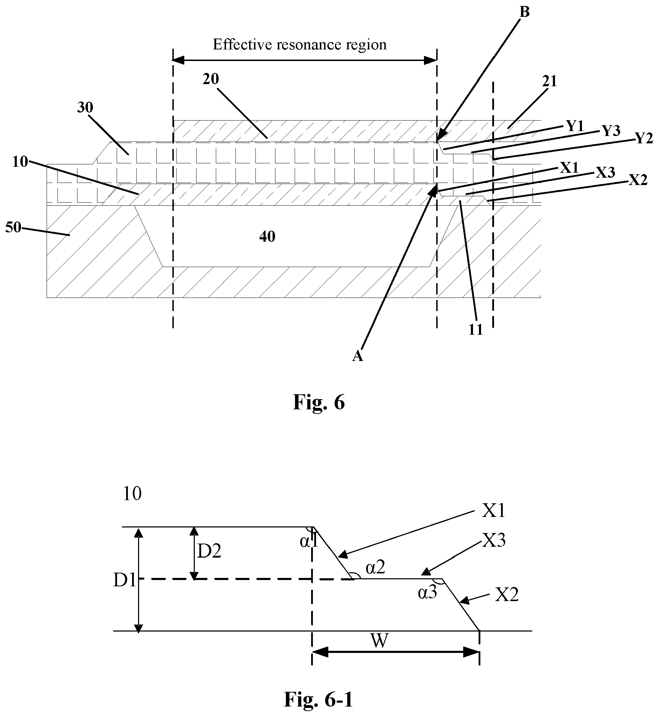

In an embodiment of the present disclosure, combined with Figures 5 and 6, Figure 6 is a schematic enlarged view of a bulk acoustic resonator shown in Figure 5. It can be seen from Figure 6 that the contact surface between the first thinning region 11 and the piezoelectric layer 30 is step-shaped. Specifically, the contact surface between the first thinning region 11 and the piezoelectric layer 30 includes a first inclined plane X1, a second inclined plane X2, and a first plane X3 connecting the first inclined plane X1 and the second inclined plane X2. In the direction from the first electrode 10 to the second electrode 20, the first inclined plane X1 is higher than the second inclined plane X2.

In the embodiment, the step-shaped first thinning region 11 may be formed on the first electrode 10 through an etching process.

In the embodiment, when the piezoelectric layer 30 is deposited on the first thinning region 11, a step morphology is transferred to the upper surface of the piezoelectric layer 30 through morphology transfer. Therefore, the upper surface of the piezoelectric layer 30 includes a third inclined plane Y1, a fourth inclined plane Y2, and a second plane Y3 connecting the third inclined plane Y1 and the fourth inclined plane Y2. In the direction from the first electrode 10 to the second electrode 20, the third inclined plane Y1 is higher than the fourth inclined plane Y2. The first inclined plane X1 of the first thinning region corresponds to the third inclined plane Y1 of the piezoelectric layer, the first plane X3 of the first thinning region corresponds to the second plane Y3 of the piezoelectric layer, and the second inclined plane X2 of the first thinning region corresponds to the fourth inclined plane Y2 of the piezoelectric layer. That is, a step morphology of the upper surface of the first thinning region 11 is completely the same as a step morphology of the upper surface of the piezoelectric layer 30.

It should be noted that longitudinal waves propagating along a thickness direction of the piezoelectric layer 30 plays a major role in the bulk acoustic resonator. However, it is inevitable that some transverse waves propagating along a direction parallel to a plane where the substrate 50 is located may be excited, and the transverse waves are easily leaked from side edges of the effective resonance region, resulting in the acoustic energy loss. In the embodiment, on the upper surface of the piezoelectric layer 30, the step morphology formed by the third inclined plane Y1, the second plane Y3 and the fourth inclined plane Y2 is located close to the edge of the effective resonance region, and the step morphology is a boundary between the piezoelectric layer and the air or another medium filled with the first gap K1, thus generating a change in the acoustic impedance. Therefore, transverse wave resonance can be suppressed, transverse wave leakage can be reduced, that is, the acoustic energy loss can be reduced, and the quality factor (Q factor) of the bulk acoustic resonator can be improved.

In the embodiment, the first inclined plane X1 may be parallel to the second inclined plane X2, which is not limited in the present disclosure. That is, the first inclined plane X1 may not be parallel to the second inclined plane X2.

In the embodiment, combined with Figures 6 and 6-1, Figure 6-1 is a schematic enlarged view of the first thinning region 11 shown in Figure 6. An angle between the first inclined plane X1 and the upper surface of the first electrode within the effective resonance region is a first included angle a1, and the first included angle a1 is greater than 90 degree. Similarly, an angle between the first inclined plane X1 and the first plane X3 is a second included angle a2, and the second included angle a2 is also greater than 90 degree. An angle between the second inclined plane X2 and the first plane X3 is a third included angle a3, and the third included angle a3 is also greater than 90degree. In a case that the first inclined plane X1 is parallel to the second inclined plane X2, the first included angle a1, the second included angle a2, and the third included angle a3 are equal. It can be understood that a slope of the first thinning region 11 is gentler with increases of the first included angle a1, the second included angle a2, and the third included angle a3. During the subsequent growth of the piezoelectric layer, the gentle slope of the first thinning region 11 is conducive to the growth of the piezoelectric layer, which can reduce the stress mutation of the piezoelectric layer close to the edge of the effective resonance region, and reduce the defect, fracture, and other anomalies caused by the sudden morphological change in the steps in the piezoelectric layer.

It can be seen that the first inclined plane X1 and the second inclined plane X2 may be replaced by two vertical planes. However, compared with the inclined plane, the vertical planes make the piezoelectric layer easily produce more defects at the vertical planes due to the morphological change. That is, compared with the vertical planes, the inclined planes are more conducive to the growth of the piezoelectric layer, and are more conducive to reducing the discontinuity of the growth of the piezoelectric layer at the step.

In addition, the first inclined plane X1 and the second inclined plane X2 may be replaced by two arc-shaped planes. Compares with the inclined planes, the arc-shaped planes make the growth of the piezoelectric layer being more continuous and have fewer defects.

In the embodiment, the number of steps included in the contact surface between the first thinning region 11 and the piezoelectric layer 30 is not limited, that is, the contact surface between the first thinning region 11 and the piezoelectric layer 30 may include one step or multiple steps. However, it can be understood that compared with the one step, the multiple steps make a stress effect reduce (as the stress effect may be decomposed into two or more parts, causing stress dispersion) during the growth of the piezoelectric layer, and make the piezoelectric layer 30 produce fewer defects at a starting position (that is, a starting position of the slope morphology) of the first thinning region 11.

In the embodiment, as shown in Figure 6, an intersection point between the upper surface of the part of the first electrode 10 within the effective resonance region and the first inclined plane X1 is a point A, and an intersection point between the upper surface of the piezoelectric layer 30 within the effective resonance region and the third inclined plane Y1 is a point B. The point A is located inside the acoustic reflection component 40 to ensure that the point B is also located inside the acoustic reflection component 40 or coincides with the edge of the acoustic reflection component 40.

In the embodiment, as shown in Figure 6-1, in the direction from the first electrode 10 to the second electrode 20, a thickness of the first electrode 10 is D1, and a distance from the first plane X3 to the upper surface of the first electrode within the effective resonance region is D2. D2 may be less than or equal to a half of D1, so that a starting position of the first thinning region 11 is gentle, and the piezoelectric layer has no sudden morphological change, reducing defects in the piezoelectric layer.

A height and a width of the first thinning region 11 in the first electrode 10 determines a size of the first gap K1. In order to minimize the defect region of the piezoelectric layer and minimize the stress mutation of the piezoelectric layer, a height of the first gap K1 may range from 10nm to 100nm, and a width W (W as shown in Figure 6-1) of the first thinning region 11 may range from 100nm to 500nm.

It should be noted that if the piezoelectric layer 30 has the slight defect and stress mutation at a starting position of the step (at the starting position of the first thinning region), an effective electromechanical coupling coefficient of a piezoelectric film is increased to eliminate the slight effect of the defect and stress mutation. An AlN piezoelectric material is taken as an example, Scandium element may be doped with a doping ratio ranging from 7% to 25%. ScAlN with different Sc ratios may be used to eliminate the slight effect of the defect and the stress mutation of the piezoelectric layer at the starting position of the step (at the starting position of the first thinning region).

In another embodiment of the present disclosure, as shown in Figures 7 and 7-1, the contact surface between the first thinning region 11 and the piezoelectric layer 30 may be inclined-shaped.

In the embodiment, an inclined sidewall (that is, the first thinning region 11) may be formed at the end of the first electrode 10 by etching. The inclined sidewall starts at a position inside the acoustic reflection component 40, and the inclined sidewall has a small inclined angle, so that the inclined sidewall is gentle and the piezoelectric layer has fewer defects.

In the embodiment, the acoustic reflection component 40 in Figure 7 is the cavity, and the acoustic reflection component 40 in Figure 7-1 is the Bragg reflector. It can be understood that in a case that the acoustic reflection component 40 is the Bragg reflector, the first electrode 10 may partially cover the acoustic reflection component 40, which indicates that the first electrode 10 may partially cover the acoustic reflection component 40, avoiding that the bottom of the piezoelectric layer is significantly deformed due to lack of the support.

In another embodiment of the present disclosure, as shown in Figure 8, the contact surface between the first thinning region 11 and the piezoelectric layer 30 may be arc-shaped.

In the embodiment, as shown in Figure 8, the acoustic reflection component 40 is located on the surface of the substrate 50, which is an above-ground type. It can be seen that the contact surface between the first thinning region 11 and the piezoelectric layer 30 is arc-shaped, which is also applicable to the case where the acoustic reflection component 40 is embedded into the substrate 50.

In the embodiment, an end of the acoustic reflection component 40 may be arc-shaped, so that the first electrode 10 covers the acoustic reflection component 40, to form an arc-shaped slope morphology on the first electrode 10. In order to ensure that the first gap K1 formed after the subsequent deposition of the piezoelectric layer starts at a position inside the acoustic reflection component 40, the first electrode 10 with the arc-shaped slope morphology is etched to form the first thinning region 11.

In the embodiment, the contact surface between the first thinning region 11 and the piezoelectric layer 30 is arc-shaped, which is conducive to the continuous growth of the piezoelectric layer, and the piezoelectric layer has fewer defects and higher quality.

Based on the any one of the above embodiments, in an embodiment of the present disclosure, as shown in Figures 5 and 5-1, 7 and 7-1, another side of the first thinning region 11 coincides with the end of the first electrode 10, so that the piezoelectric layer 30 extends from the effective resonance region along the first thinning region 11 to the surface of the substrate 50, covering the surface of the substrate 50.

In another embodiment of the present embodiment, as shown in Figure 8, another side of the first thinning region 11 has a distance with the end of the first electrode 10, so that the piezoelectric layer 30 extends from the effective resonance region along the piezoelectric layer 30 extends from the effective resonance region along the first thinning region 11, and then covers the first electrode 10 for a distance to the surface of the substrate 50, covering the surface of the substrate 50.

It should be noted that whether the another side of the first thinning region 11 coincides with the end of the first electrode 10 or has a distance with the end of the first electrode 10, in a case that the acoustic reflection component 40 is the cavity and the end of the first electrode 10 is located outside the edge of the acoustic reflection component 40, a side of the first thinning region 11 is required to be located inside the cavity and another side of the first thinning region 11 is required to be located outside the edge of the cavity to support the piezoelectric layer, improving mechanical stability. In a case that the acoustic reflection component 40 is the Bragg reflector, a side of the first thinning region 11 is located inside the Bragg reflector, and another side of the first thinning region 11 may be located outside the edge of the Bragg reflector, may coincide with the edge of the Bragg reflector, or may be located inside the edge of the Bragg reflector, depending on the situation.

In the above embodiments, the first electrode 10 is etched to form the first thinning region 11, so that the piezoelectric layer 30 directly covers the first thinning region 11, to form the first gap K1 between the piezoelectric layer 30 and the second electrode connection part 21. In addition, in addition to etching the first electrode to form the first thinning region, the first thinning region may further be formed by stacking metal electrodes, where the first electrode is a composite metal electrode.

In an embodiment of the present disclosure, as shown in Figure 5-2, the first electrode 10 includes a first metal electrode M1 and a second metal electrode M2 that are arranged to be stacked. The second metal electrode M2 is located on a side of the first metal electrode M1 close to the piezoelectric layer 30, and ends of the second metal electrode M2 are shrunk in relative to ends of the first metal electrode M1 to form a first thinning region 11.

In the embodiment, the first electrode 10 is the composite electrode formed by stacking metal electrodes arranged in multiple layers. The first electrode 10 may only include metal electrodes arranged in two layers or metal electrodes arranged in multiple layers, and ends of a metal electrode arranged in an upper layer are shrunk in relative to ends of a metal electrode arranged in a lower layer, that is, a size of the metal electrode arranged in the upper layer is smaller than a size of the metal electrode arranged in the lower layer. In this way, a step-shaped first thinning region 11 is formed at the end of the first electrode 10, so that the piezoelectric layer 30 directly covers the first thinning region 11, to form the first gap K1 formed between the piezoelectric layer 30 and the second electrode connection part 21.

In the embodiment, metal electrodes arranged in different layers in the first electrode 10 may be made of a same material or different materials, and the metal electrodes arranged in different layers in the first electrode 10 may be of a material with high acoustic impedance and high conductivity, to enhance the performance of the resonator.

According to the above embodiments, the slope morphology is formed on the upper surface of the first electrode by thinning the first electrode 10 (including etching or stacking metal electrodes arranged in multiple layers). Hereinafter, how to form the slope morphology on the upper surface of the first electrode without thinning the first electrode 10 is described.

In an embodiment of the present disclosure, as shown in Figure 9, the acoustic reflection component 40 is located on the surface of the substrate 50, and the first electrode 10 protrudes upwards on the surface of the substrate 50, so that the acoustic reflection component 40 is located between a protruding upwards part of the first electrode and the surface of the substrate, and the piezoelectric layer 30 directly covers the first electrode 10 to form the first gap K1 between the piezoelectric layer 30 and the second electrode connection part 21.

In the embodiment, the acoustic reflection component 40 is located above the surface of the substrate, and the end of the acoustic reflection component 40 is inclined, so that the first electrode 10 covers the end of the acoustic reflection component 40, to form a slope morphology. Therefore, the piezoelectric layer 30 directly covers the first electrode 10, to form the first gap K1 between the piezoelectric layer 30 and the second electrode connection part 21, and the first gap K1 starts at a position located inside the acoustic reflection component 40, or at a position that coincides with the edge of the acoustic reflection component 40. The first electrode 10 in the embodiment is similar to the first electrode 10 shown in Figure 8, with a difference in that in Figure 8, the first electrode 10 covers the acoustic reflection component 40 to form the slope morphology, the first electrode 10 is etched at the slope morphology to form the first thinning region 11, while In Figure 9, the first electrode 10 covers the acoustic reflection component 40 to form the slope morphology, and the first electrode 10 is not etched, so as to simplify the process.

In the embodiment, an inclination of the end of the acoustic reflection component 40 is required to be control to ensure that the first electrode 10 covers the acoustic reflection component 40, and the first gap K1 formed when the piezoelectric layer 30 covers the first electrode, at least starts from the edge of the acoustic reflection component 40 or an inside of the acoustic reflection component 40.

In the embodiment, since the end of the acoustic reflection component 40 is inclined, in the actual process, a part of the first electrode 10 located at the end of the acoustic reflection component 40 is thinned relative to the part of the first electrode 10 within the effective resonance region, and the thinned part of the first electrode 10 depends on the thinning process.

In the embodiment, the first electrode 10 is not subjected to etching and other physical damage, the distribution of the stress of the piezoelectric layer 30 is uniform, and the resonator has a good performance and a high yield.

Based on any one of the above embodiments, in an embodiment of the present disclosure, as shown in Figures 5, 7, and 9, in the direction from the first electrode 10 to the second electrode 20, the upper surface of the second electrode connection part 21 is not higher than an upper surface of a part of the second electrode within the effective resonance region. That is, in the embodiment, the second electrode connection part 21 extends horizontally from the part of the second electrode within the effective resonance region, or extends towards a side of the piezoelectric layer 30, and the connection part 21 does not protrude upwards to form a bridge structure.

In an embodiment of the present disclosure, as shown in Figures 5, 7, and 9, the upper surface of the second electrode connection part 21 is flush with the upper surface of the part of the second electrode within the effective resonance region.

Normally, the part of the second electrode within the effective resonance region and the second electrode connection part 21 are made of a same metal electrode and formed in a same process. In the embodiment, the upper surface of the second electrode connection part 21 is flush with the upper surface of the part of the second electrode within the effective resonance region, and an upper surface of a part of the first gap K1 below the second electrode connection part 21 does not exceed the upper surface of the piezoelectric layer 30 within the effective resonance region. Therefore, the second electrode connection part 21 is horizontally flat and not bent.

In the embodiment, since the second electrode connection part 21 is horizontally flat and not bent, in response to the problem (1) of the air bridge protruding upwards serving as the top electrode connection part, in the bulk acoustic resonator according to the embodiment, the second electrode connection part has good mechanical stability, and is not easily collapsed and fractured. Moreover, in response to the problem (2) of the air bridge protruding upwards serving as the top electrode connection part, the horizontally flat second electrode connection part has a shortest length, thus the length is not shortened by external force like the air bridge, and a commonly used Mo material for the second electrode has a high hardness, so that the horizontally flat second electrode connection part 21 may provide a transverse stretching effect for the central region of the resonator, thereby preventing the center region of the resonator from being collapsed or deformed.

It is found that in addition to the above problems (1) and (2), the air bridge protruding upwards serving as the top electrode connection part further has the following problems (3), (4) and (5).

(3) A passivation layer formed above the air bridge is non-uniform.

In practices, after the second electrode is manufactured, the second electrode is required to be deposited to form the passivation layer. Due to a non-uniform structure of the air bridge, the passivation layer formed above the air bridge is non-uniform. Specifically, the passivation layer (having a typical thickness ranging from 50nm to 100nm) has a small thickness when being deposited at an inclined position, while the passivation layer has a large thickness when being deposited a flat position. The non-uniform thickness of the passivation layer affects the uniformity of frequency distribution, and every thickness of 1nm affects a frequency of 1MHz.

In the embodiment, the horizontally flat second electrode connection part 21 can improve the uniformity of the thickness of the passivation layer, achieving centralized frequency distribution, thereby improving the yield of the resonator.

(4) A process of the air bridge manufactured as the top electrode connection part is not easily accurately controlled.

Since the effective resonance region of the resonator is usually determined by the second electrode 20, it is crucial that the second electrode, the piezoelectric layer, and first electrode are arranged to be aligned. The unaligned arrangement may affect the consistency of models of the resonator, and the processed resonator may have a deviation from the designed model, affecting the yield of the resonator.

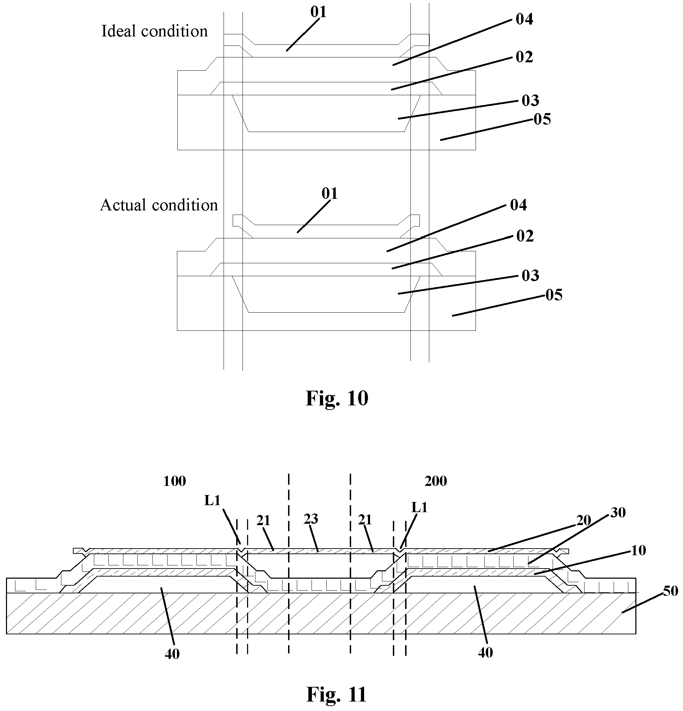

In a case that the air bridge serves as the top electrode connection part, the top electrode has a protruding morphology, as shown in Figure 10. In Figure 10, 01 represents the top electrode, 02 represents the bottom electrode, 03 represents the acoustic reflection component, 04 represents the piezoelectric layer, and 05 represents the substrate. An image on the photoresist is deformed or offset after exposure and developing due to the impact of the protruding morphology, and thus a photolithography effect and an etching effect of a region close to the protruding morphology are greatly affected. There is a morphological issue on the etching effect due to the deformation of the pattern on the photoresist. As shown in Figure 10, in a case that a structure protruding upwards is etched, photoresist on sides of the protruding structure is relatively thin, a pattern on the photoresist is deviated when distortion occurs during photolithography, resulting in a deviation between an actual cantilever length and an ideal cantilever length. A change in the cantilever length has a significant impact on the performance of the resonator. If the cantilever length does not reach a preset value, affecting a parallel impedance Rp of the resonators, and reducing Qp, thereby reducing a Q value (characterized by Qs and Qp) of the resonator. As a result, the yield of the resonator is seriously affected, and it is difficult to optimize the process, indirectly significantly increasing the cost.

In the embodiment, the second electrode connection part 21 is horizontally flat. A photolithography effect and an etching effect on the horizontal plane are the best, and the alignment effect between the metal layer and the piezoelectric layer is the best and the simplest, so that the processing process is easily controlled and optimized, and the cost is low, achieving a better result.

(5) Resistance is large in a case that the air bridge serves as the top electrode connection part.

It can be understood that the top electrode connection part in the air bridge structure results in a large electrical connection length between adjacent resonators (due to the protruding bridge), a long electrical signal propagation path. As a result, the loss is large, especially the electrode has a small thickness at a high frequency, and the electrical connection length is very sensitive to the resistance, thus affecting the series impedance Rs of the resonator. Specifically, in a case that the electrical connection length is large, resistance of the electrode is large, resulting in a large Ohmic loss. As a result, more electrical energy is converted into thermal energy and dissipated into the air, increasing the loss, increasing the series impedance Rs of the resonator, reducing Qs of the resonator, thus reducing the Q factor of the resonator (characterized by Qs and Qp). In a filter, the series impedance Rs and the parallel impedance Rp of the resonator determine a passband insertion loss and a return loss. Generally, a high parallel impedance Rp of the resonators and a low series impedance Rs of the resonator indicates a low passband insertion loss of the filter. It can be seen that a long electrical connection length may deteriorate the performance of the resonator and further affect the performance of the filter.

In the embodiment, as a straight connection is the shortest and optimal connection way, the second electrode connection part 21 in the embodiment is horizontally flat, which can greatly shorten the electrical connection length between adjacent resonators, reduce the acoustic energy loss, and improve the Q factor of the resonator.

Based on the above embodiments, in an embodiment of the present disclosure, as shown in Figure 5, Figures 7 to 9, the second electrode connection part 21 is directly horizontally connected to the part of the second electrode within the effective resonance region.

Considering the actual process, in another embodiment of the present disclosure, as shown in Figure 11, the second electrode connection part 21 is connected to the part of the second electrode within the effective resonance region through a recess part L1. A part of the recess part L1 connected to the part of the second electrode within the effective resonance region directly contacts with the piezoelectric layer 30.

In the embodiment, the recess part L1 is V-shaped or U-shaped, and a shape of the recess part L1 is not limited in the present disclosure, depending on the situation.

In the embodiment, the recess part L1 is located close to the edge of the effective resonance region, and the recess part L1 forms a boundary between the second electrode and the air or other medium filled in the recess part L1, thus generating a change in the acoustic impedance. Therefore, transverse wave resonance can be suppressed, transverse wave leakage can be reduced, that is, the acoustic energy loss can be reduced, and the quality factor of the bulk acoustic resonator can be improved.

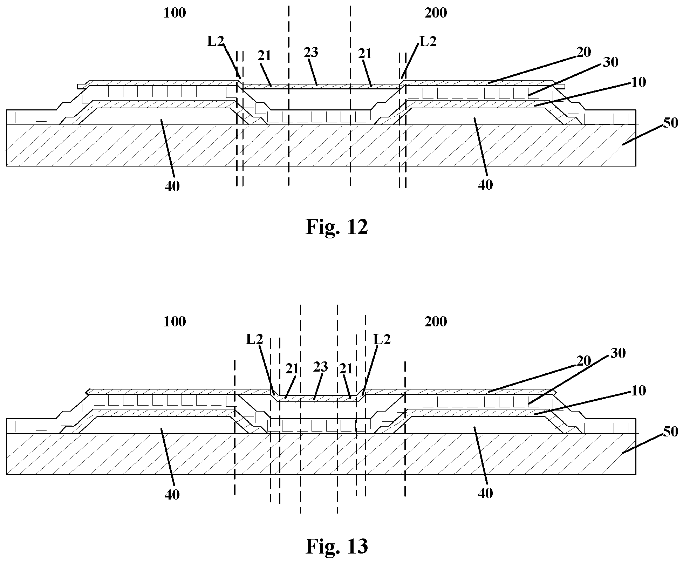

In another embodiment of the present disclosure, as shown in Figures 12 and 13, in the direction from the first electrode 10 to the second electrode 20, the upper surface of the second electrode connection part 21 is lower than the upper surface of the part of the second electrode within the effective resonance region, and the second electrode connection part 21 is connected to the part of the second electrode within the effective resonance region through an inclined part L2.

Based on the embodiment, in an embodiment of the present disclosure, as shown in Figure 12, the inclined part L2 directly contacts with the piezoelectric layer.

In another embodiment of the present disclosure, as shown in Figure 13, the part of the second electrode within the effective resonance region extends horizontally for a distance to connect to the inclined part L2, so that the inclined part L2 does not contact with the piezoelectric layer 30. The inclined part L2 causes a morphological change at a position, which can reflect the transverse sound wave, reduce acoustic energy loss, and improve the Q factor.

Based on any one of the above embodiments, in an embodiment of the present disclosure, as shown in Figures 5-2 to 5-4, Figures 7 to 7-1, Figures 8 and 9, a part of the second electrode other than the second electrode connection part 21 extends away from the effective resonance region to form an second electrode extension part 22, a second gap K2 is formed between the second electrode extension part 22 and the piezoelectric layer 30. In the direction from the first electrode 10 to the second electrode 20, an upper surface of the second gap K2 is not higher than the upper surface of the part of the piezoelectric layer within the effective resonance region.

It should be noted that the part of the second electrode within the effective resonance region normally includes multiple lateral sides. The second electrode connection part 21 is connected to a lateral side of the part of the second electrode within the effective resonance region. In the embodiment, other lateral sides (that is, non-connecting ends of the second electrode) of the part of the second electrode within the effective resonance region other than lateral sides connected to the second electrode connection part extends away from the effective resonance region to form the second electrode extension part 22. Alternatively, the second electrode extension part 22 may be formed on one or more lateral sides of the non-connecting ends of the second electrode, and the second gap K2 is formed between the second electrode extension part 22 and the piezoelectric layer.

In the embodiment, in the direction from the first electrode 10 to the second electrode 20, the upper surface of the second gap K2 is not higher than the upper surface of the part of the piezoelectric layer within the effective resonance region, and the upper surface of the first gap K1 is also not higher than the upper surface of the part of the piezoelectric layer within the effective resonance region. Therefore, the entire second electrode 20 may be horizontally flat, and has a good mechanical stability.

Moreover, similar to the first gap K1, the second gap K2 starts at a position inside the acoustic reflection component 40 or at a position that coincides with the edge of the acoustic reflection component 40, and extends to a position outside the acoustic reflection component 40. In such case, the second gap K2 is located at the end of the effective resonance region, and a change in the acoustic impedance may be generated between the piezoelectric layer 30 and the air or other medium filled in the second gap K2. Therefore, transverse wave resonance can be suppressed, transverse wave leakage can be reduced, that is, the acoustic energy loss can be reduced, and the quality factor of the bulk acoustic resonator can be improved.

Based on the above embodiments, in an embodiment of the present disclosure, as shown in Figures 5-2 to 5-4, Figures 7 to 7-1, and Figure 8, the first electrode 10 further includes a second thinning region 12. A thickness of the second thinning region 12 is less than the thickness of the part of the first electrode 10 within the effective resonance region, so that the piezoelectric layer 30 directly covers the second thinning region 12, to form the second gap K2 between the piezoelectric layer 30 and the second electrode extension part 22.

Similar to the first thinning region 11, in order to form the second gap K2 between the second electrode extension part 22 and the piezoelectric layer 30, a side of the second thinning region 12 is located inside the acoustic reflection component 40. Another side of the second thinning region 12 may coincide with the end of the first electrode 10 or have a distance from the end of the first electrode 10.

Similar to the first thinning region 11, a contact surface between the second thinning region 12 and the piezoelectric layer 30 may be step-shaped, arc-shaped, or inclined-shaped. Alternatively, the second gap K2 may further be a groove shown in Figure 5-4, and an end of the second electrode extension part 22 does not exceed an edge of the groove, to avoid additional parasitic oscillation.

Similar to the first thinning region 11, the second thinning region 12 in the first electrode 10 may be formed by etching process or by stacking metal electrodes arranged in multiple layers, depending on the situation.

Similar to the first gap K1 between the second electrode connection part 21 and the piezoelectric layer 30, for the second gap K2 between the second electrode extension part 22 and the piezoelectric layer 30, the second thinning region 12 may be first formed in the first electrode 10, and then the piezoelectric layer 30 is deposited on the second thinning region 12, so that a morphology of the second thinning region 12 is directly transferred to the upper surface of the piezoelectric layer 30, and thus the second gap K2 is formed between the second electrode extension part 22 and the piezoelectric layer 30.

Similar to the first gap K1 between the second electrode connection part 21 and the piezoelectric layer 30, for the second gap K2 between the second electrode extension part 22 and the piezoelectric layer 30, the acoustic reflection component 40 may be arranged on the surface of the substrate 50, the end of the acoustic reflection component 40 is arranged to be inclined-shaped, and the first electrode 10 covers the end of the acoustic reflection component 40 to form a slope morphology, so that the piezoelectric layer 30 directly covers the first electrode 10, to form the second gap K2 between the piezoelectric layer 30 and the second electrode extension part 22, and the second gap K2 starts at a position inside the acoustic reflection component 40 or at a position that coincides with the edge of the acoustic reflection component 40.

In summary, in the bulk acoustic resonator according to the embodiments of the present disclosure, the slope morphology is formed on the upper surface of the first electrode, the slope morphology is directly transferred to the upper surface of the piezoelectric layer when the piezoelectric layer is deposited on the first electrode, and then the first gap is formed between the second electrode connection part and the piezoelectric layer, so that the second electrode connection part is separated from the piezoelectric layer, avoiding the parasitic oscillation caused by overlapping of the second electrode connection part and the first electrode on the region outside the acoustic reflection component. In addition, in the direction from the first electrode to the second electrode, the upper surface of the first gap is not higher than the upper surface of the part of the piezoelectric layer within the effective resonance region, so that the mechanical stability of the second electrode connection part is improved and the second electrode connection part is not easily collapsed and fractured. The piezoelectric layer has a constant thickness, and is not subjected to etching and other physical damage, so that the local stress of the piezoelectric layer is not damaged, the stress distribution of the piezoelectric layer is uniform, the yield and the effective electromechanical coupling coefficient of the resonator are improved, ensuring the mechanical strength and reliability of the resonator. Moreover, the growth of the piezoelectric layer by means of morphology transfer is simple and easy to implement.

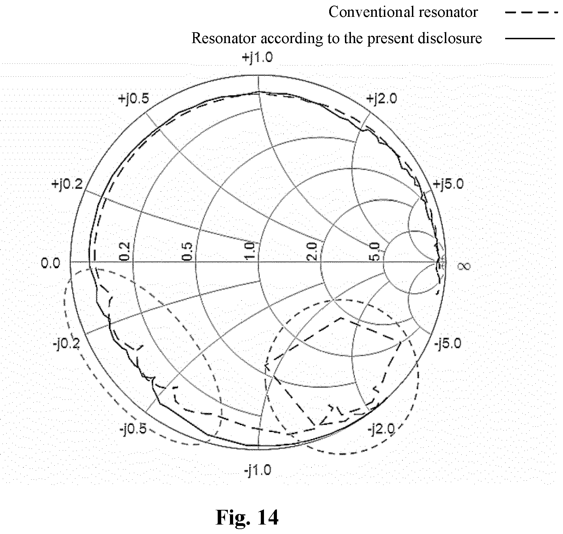

Figure 14 is a schematic diagram of a Smith circle of the bulk acoustic resonator shown in Figure 5 according to the present disclosure and a conventional bulk acoustic resonator in a sandwiched structure. In the Smith circle, a small circle, a large number of break points, and a large amplitude indicate a strong parasitic mode and a large stray mode, and a large circle, a small number of break points, and a small amplitude indicate a weak parasitic mode and a small stray mode. In the Smith circle, a curve close to an outer side of the circle indicates that the curve is smooth, and a return loss of the resonator is small. From Figure 14, it can be seen that compared with the conventional bulk acoustic resonator in the sandwiched structure, in a Smith circle of the bulk acoustic resonator according to the present disclosure, the circle is small, the number of break points is small, the amplitude is small, weak parasitic mode, and the curve is closer to the outer side of the circle, a return loss of the resonator is small.

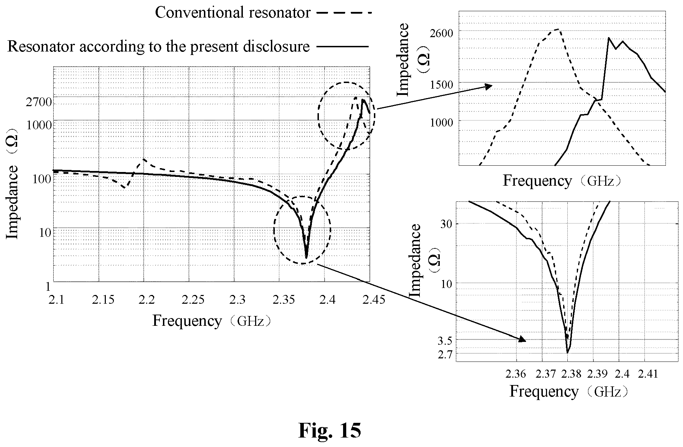

Figure 15 is a schematic diagram of impedance variation with frequency of a bulk acoustic resonator shown in Figure 5 according to the present disclosure and a conventional bulk acoustic resonator in a sandwiched structure. As the parasitic oscillation of the resonator decreases, the series impedance Rs of the resonators also decreases, thereby increasing the Q value of the resonator. From Figure 15, it can be seen that a frequency close to 2.1GHz is taken as an example, series impedance Rs of the bulk acoustic resonator according to the present disclosure is 2.7Ω, while series impedance Rs of the conventional bulk acoustic resonator in the sandwiched structure is 3.5Ω, so that the bulk acoustic resonator according to the present disclosure significantly reduces parasitic resonance, especially a significant decrease in the parasitic resonance at a frequency close to 2. 18GHz.

A resonator assembly is further provided according to an embodiment of the present disclosure, as shown in Figures 5 to 5-3, Figures 7 to 7-1, and Figures 8 and 9. The resonator assembly at least includes a first resonator 100, an electrical component 200, and a connection structure 23. The first resonator 100 is the bulk acoustic resonator according to any one of the above embodiments. Two ends of the connection structure 23 are connected to a second electrode connection part 21 in the first resonator 100 and the electrical component 200, respectively.

It should be noted that the first resonator has advantages of low parasitic oscillation, high mechanical stability, uniform stress distribution in the piezoelectric layer, high performance and high yield. Therefore, the resonator assembly also has high performance.

In an embodiment of the present disclosure, the electrical component 200 is also a bulk acoustic resonator, that is, the connection structure 23 is connected to two bulk acoustic resonators. Specifically, Figures 5 to 5-3, Figures 5-5 to 5-8, Figures 7 to 7-1, Figures 8 to 8-3, and Figures 9 to 9-3 are schematic diagrams of the connection structure 23 connecting two bulk acoustic resonators. The electrical component 200 may be a resonator identical to the first resonator 100, that is, the electrical component 200 also includes the first electrode 10, the second electrode 20, and the piezoelectric layer 30 arranged between the first electrode 10 and the second electrode 20. The acoustic reflection component 40 is arranged on a side of the first electrode 10 away from the piezoelectric layer 30. An overlapping part of the acoustic reflection component 40, the first electrode 10, the piezoelectric layer 30, and the second electrode 20 is defined as an effective resonance region. The second electrode 20 includes a second electrode connection part 21 in addition to a part located within the effective resonance region. The piezoelectric layer 30 extends beyond an end of the first electrode 10, and has a constant thickness. A first gap K1 is formed between the second electrode connection part 21 and the piezoelectric layer 30. In a direction from the first electrode 10 to the second electrode 20, an upper surface of the first gap K1 is not higher than an upper surface of a part of the piezoelectric layer 30 within the effective resonance region.

In an embodiment of the present disclosure, the electrical component 200 may include such as an inductor, a capacitor, a pad or other electrical components. Specifically, Figures 5-9 to 5-10 and Figure 9-4 are schematic diagrams of the connection structure for connecting the first resonator 100 to an inductor, a capacitor, a pad or other electrical components. The inductor, the capacitor, the pad or other electrical components are not illustrated in the diagrams, and only a metal layer connecting the inductor, the capacitor, the pad or other electrical components to the first resonator 100 is illustrated in the diagrams.

Based on any one of the above embodiments, in an embodiment of the present disclosure, in the direction from the first electrode 10 to the second electrode 20, an upper surface of the connection structure 23 is not higher than an upper surface of a part of the second electrode within the effective resonance region in the first resonator 100.

In an embodiment of the present disclosure, in the direction from the first electrode 10 to the second electrode 20, the upper surface of the connection structure 23 is flush with the upper surface of the part of the second electrode within the effective resonance region in the first resonator. A third gap K3 is formed between the connection structure 23 and the piezoelectric layer, as shown in Figures 5 to 5-3, Figures 5-8 to 5-10, Figures 7 to 7-1, Figures 8 and 9.

In the embodiment, both the connection part 21 of the second electrode and the connection structure 23 in the first resonator 100 may be flush with the upper surface of the part of the second electrode within the effective resonance region in the first resonator 100, and the piezoelectric layer 30 extends from the effective resonance region of the first resonator to the surface of the substrate 50, so that the third gap K3 is formed between the connection structure 23 and the piezoelectric layer 30.

It should be noted that in practices, although the second electrode 20 and the connection structure 23 are deposited simultaneously and arranged in a same metal layer, the connection structure 23 is normally required to be etched, and the third gap K3 is formed between the connection structure 23 and the piezoelectric layer 30, so that the piezoelectric layer 30 below the connection structure 23 is not damaged when the connection structure 23 is etched, ensuring the integrity of the piezoelectric layer 30 on a surface of the entire resonator assembly, avoiding a stress change to a part of the piezoelectric layer close to the effective resonance region, and greatly improving a power tolerance and the performance of anti-electrostatic breakdown of the resonator assembly.

Moreover, in the embodiment, both the second electrode connection part 21 and the connection structure 23 in the first resonator 100 may be flush with the upper surface of the part of the second electrode within the effective resonance region in the first resonator 100, having the following advantages.
(a) The entire second electrode 20 and the connection structure 23 are horizontally flat and not bended, so that mechanical stability is high.
(b) The horizontal second electrode connection part 21 and the connection structure 23 cannot be shortened in length, and thus provides a transverse stretching effect (where force is shown by the arrow in Figure 5) for the central region of the resonator, thereby preventing the central area of the resonator from being collapsed and deformed.
(c) The passivation layer grown above the horizontal second electrode 20 and the connection structure 23 has high uniformity in the thickness, facilitating centralized frequency distribution, thereby improving the yield of the resonator.
(d) The photolithography effect and the etching effect of the horizontal second electrode 20 and the connection structure 23 are the best, and the alignment effect between the metal layer and the piezoelectric layer is the best, so that the processing process is optimized and the cost is low.
(e) The horizontal second electrode connection part 21 and the connection structure 23 make a connection distance from the first resonator 100 to other electrical components the shortest, and make connection resistance the smallest, thus reducing the acoustic wave loss and improving the quality factor (Q factor) of the resonator.

In another embodiment of the present disclosure, in the direction from the first electrode 10 to the second electrode 20, the upper surface of the connection structure 23 is lower than the upper surface of the part of the second electrode within the effective resonance region in the first resonator 100, and the third gap K3 is formed between the connection structure 23 and the piezoelectric layer 30, as shown in Figures 5-6, 8-2, and 9-2. Alternatively, the connection structure 23 directly contact with the piezoelectric layer 30, as shown in Figures 5-7, 8-3, and 9-3.

As described above, the third gap K3 is formed between the connection structure 23 and the piezoelectric layer 30, so that the piezoelectric layer 30 below the connection structure 23 is not damaged when the piezoelectric layer 30 below the connection structure 23 is not damaged is etched, ensuring the integrity of the piezoelectric layer on the surface of the entire resonator.

In a case that the connection structure 23 directly contact with the piezoelectric layer 30, the connection structure 23 is supported by the piezoelectric layer 30, so that the connection structure 23 has high mechanical stability.

Based on any one of the above embodiments, in an embodiment of the present disclosure, two ends of the connection structure 23 are directly connected to the second electrode connection part 21 in the first resonator 100 and the electrical component 200, respectively.

In another embodiment of the present disclosure, a side the second electrode connection part 21 close to the connection structure 23 includes at least one concave-convex structure L3. The connection structure 23 is connected to at least one of the second electrode connection part 21 in the first resonator 100 and the electrical component 200 through the at least one concave-convex structure L3, as shown in Figures 5-5, 8-1, and 9-1.

It should be noted that in Figures 5-5, 8-1, and 9-1, the second electrode connection part 21 in the first resonator 100 and the connection structure 23 may be regarded as be approximately flush. A cause of the concave-convex structure L3 formed at a connection end of the two is as follows. Whether the first gap K1 between the second electrode connection part 21 and the piezoelectric layer 30 in the first resonator 100, or the third gap K3 between the connection structure 23 and the piezoelectric layer 30, the first gap K1 and the third gap K3 are formed by filling a sacrificial layer at a position a to-be-formed gap, forming the second electrode connection part 21 and connection structure 23, and then removing the sacrificial layer, so that the first gap K2 and the third gap K3 are formed.

It is found that during the manufacturing of the gaps, at least one protrusion is formed between the second electrode connection part 21 and the connection structure 23, and two sides of the protrusion are concave, forming the concave-convex structure L3. Moreover, the concave-convex structure L3 is the boundary between the air and the second electrode, resulting in the change in the acoustic impedance. Therefore, transverse wave resonance can be suppressed, transverse wave leakage can be reduced, that is, the acoustic energy loss can be reduced, and the quality factor of the bulk acoustic resonator can be improved.

In the embodiment, in a case that the electrical component 200 is also a resonator, a side of the second electrode connection part 21 close to the connection structure 23 also includes at least one concave-convex structure L3. The connection structure 23 is connected to the second electrode connection part 21 in the first resonator 100 and the second electrode connection part 21 in the electrical component 200 through at least one concave-convex structure L3. In a case that the electrical component 200 is a capacitor, an inductor, a pad or other components, the connection structure 23 may be electrically connected to the electrical component 200 through at least one concave-convex structure L3, or directly connected to the electrical component 200, and the connection structure 23 is electrically connected to the second electrode connection part 21 in the first resonator 100 through the at least one concave-convex structure 23.

It should be noted that in a case that the first resonator 100 is connected to the electrical component 200 through the second electrode connection part 21 in the first resonator 100 and the connection structure 23, the second electrode connection part 21 in the first resonator 100 and the connection structure 23 are arranged in a same metal layer. In a case that a metal layer for connecting in the electrical component 200 is the same as the metal layer of the second electrode connection part 21 in the first resonator 100 and the connection structure 23, and both the metal layers are a metal layer where the second electrode is located, the second electrode connection part 21 in the first resonator 100 may be directly connected to the electrical component 200 through the connection structure 23. In a case that the metal layer for connecting in the electrical component 200 is different from the metal layer of the second electrode connection part 21 in the first resonator 100 and connection structure 23, the second electrode connection part 21 in the first resonator 100 may be directly connected to the connection structure 23, a through hole is required to be arranged between a metal layer of the connection structure 23 and a metal layer of the electrical component 200, and a connection member is arranged in the through hole, so that the metal layer of the connection structure 23 is connected to the metal layer of the electrical component 200 through the connection member.

Hereinafter, the case that the metal layer of the electrical component 200 is the same as a metal layer of the first electrode 10 in the first resonator is described in detail.

In an embodiment of the present disclosure, as shown in Figures 5-8 to 5-10 and Figure 9-4, the second electrode 20 of the first resonator 100 is connected to the electrical component 200 through the second electrode connection part 21, the connection structure 23, and the connection member 24. The piezoelectric layer 30 is provided with a through hole, and the connection member 24 is arranged in the through hole and connected to the electrical component 200. In the direction from the first electrode 10 to the second electrode 20, the connection member 24 extends from the through hole to the upper surface of the piezoelectric layer 30.

Figures 5-8 to 5-10 are schematic diagrams that the second electrode connection part 21, the connection structure 23, and the connection member 24 arranged in the through hole penetrating the piezoelectric layer 30 in the first resonator 100 are sequentially connected to each other, so that the metal layer of the electrical component 200 is the same as the metal layer of the first electrode 10 in the first resonator 100.

It should be noted that in Figure 5-8, the electrical component 200 is a bulk acoustic resonator. Therefore, the connection member 24 is directly connected to a first electrode of the electrical component 200 at a bottom of the through hole.

In Figures 5-9, 5-10, and 9-4, the electrical component 200 may be a capacitor, an inductor, or a pad. Therefore, the connection member 24 may be directly connected to the metal layer of the electrical component 200 at the bottom of the through hole, or may extend to the upper surface of the piezoelectric layer 30, and then be connected to the metal layer of the electrical component 200. The connection manner of the connection member 24 is not limited herein, depending on the situation.

Further, alternatively, in an embodiment of the present disclosure, as shown in Figures 5-10 and 9-4, an end of the connection member 24 arranged on the upper surface of the piezoelectric layer is lifted upwards to form a lifting part 25, and a fourth gap K4 is formed between the lifting part 25 and the piezoelectric layer 30.

In the embodiment, the fourth gap K4 is formed between the lifting part 25 and the piezoelectric layer 30, preventing the piezoelectric layer 30 from being over-etched during the processing such position, simplify the processing process. The entire piezoelectric layer 30 is not subjected to physical damage or removing except for opening, avoiding a stress change to a part of the piezoelectric layer close to the effective resonance region, and greatly improving a power tolerance and the performance of anti-electrostatic breakdown of the resonator assembly.

In summary, in the resonator assembly according to the embodiments of the present disclosure, the upper surface of the connection structure for connecting the first resonator to the electrical component is not higher than the upper surface of the part of the second electrode within the effective resonance region in the first resonator. Therefore, the second electrode connection part of the first resonator and connection structure may be horizontally flat, mechanical stability is high. The horizontal second electrode connection part and the connection structure provide a transverse stretching effect for the central region of the resonator, preventing the center region of the resonator from being collapsed or deformed. The thickness of the passivation layer grown on the horizontal second electrode and the connection structure has high uniformity, facilitating the centralized frequency distribution. The photolithography effect and the etching effect of the horizontal second electrode and connection structure are the best, and the alignment effect between the metal layer and the piezoelectric layer is the best. Therefore, the processing process is optimized and the cost is low, the horizontal second electrode connection part and the connection structure make a connection distance the shortest and connection resistance the smallest, thus reducing the acoustic wave loss and improving the quality factor of the resonator.

A filter is further provided according to an embodiment of the present disclosure. The filter includes the bulk acoustic resonator according to any one of the above embodiments, or the resonator assembly according to any one of the above embodiments.

An electronic device is further provided according to an embodiment of the present disclosure. The electronic device includes the bulk acoustic resonator according to any one of the above embodiments, or the resonator assembly according to any one of the above embodiments.

The bulk acoustic resonator and the resonator assembly are described in detail in the above embodiments, which are not repeated herein.

Parts in this specification are described in a manner of combination of juxtaposition and progression. Each part focuses on differences from other parts. The same and similar parts may be referred to each other.

With the description of the embodiments disclosed above, features recorded in the embodiments in this specification may be replaced or combined with each other and those skilled in the art may implement or use technical solutions of the present disclosure. Various modifications to the embodiments are apparent to those skilled in the art, and general principles defined in the present disclosure may be implemented in other embodiments without departing from the spirit or scope of the present disclosure. Therefore, the present disclosure shall not be limited to the embodiments described herein but should comply with the widest scope consistent with the principles and novel features disclosed herein.

## Claims

1. A bulk acoustic resonator, comprising: a first electrode, a second electrode and a piezoelectric layer arranged between the first electrode and the second electrode, wherein
an acoustic reflection component is arranged on a side of the first electrode away from the piezoelectric layer, and an overlapping part of the acoustic reflection component, the first electrode, the piezoelectric layer, and the second electrode is defined as an effective resonance region;
the second electrode comprises a second electrode connection part in addition to a part of the second electrode within the effective resonance region; and
the piezoelectric layer extends beyond an end of the first electrode, a thickness of the piezoelectric layer is constant, a first gap is formed between the second electrode connection part and the piezoelectric layer, and in a direction from the first electrode to the second electrode, an upper surface of the first gap is not higher than an upper surface of a part of the piezoelectric layer within the effective resonance region.

2. The bulk acoustic resonator according to claim 1, wherein a side of the first gap is located inside the acoustic reflection component, or coincides with an edge of the acoustic reflection component, and another side of the first gap is located outside the end of the first electrode.

3. The bulk acoustic resonator according to claim 1, wherein the first gap is partially overlapped with the first electrode.

4. The bulk acoustic resonator according to claim 1, wherein the piezoelectric layer comprises a defect region with a growth defect, and the first gap at least partially covers the defect region.

5. The bulk acoustic resonator according to claim 1, wherein the end of the first electrode extends beyond an edge of the acoustic reflection component.

6. The bulk acoustic resonator according to claim 1, wherein the first electrode comprises a first thinning region, a thickness of the first thinning region is less than a thickness of a part of the first electrode within the effective resonance region, wherein the piezoelectric layer directly covers the first thinning region, to form the first gap between the piezoelectric layer and the second electrode connection part, and a side of the first thinning region is located inside the acoustic reflection component.

7. The bulk acoustic resonator according to claim 6, wherein another side of the first thinning region coincides with the end of the first electrode, or a distance between another side of the first thinning region with the end of the first electrode is provided.

8. The bulk acoustic resonator according to claim 6, wherein a contact surface between the first thinning region and the piezoelectric layer is step-shaped, arc-shaped or inclined-shaped.

9. The bulk acoustic resonator according to claim 6, wherein the first electrode comprises a first metal electrode and a second metal electrode that are arranged to be stacked, the second metal electrode is located on a side of the first metal electrode close to the piezoelectric layer, and ends of the second metal electrode are shrunk in relative to ends of the first metal electrode to form a first thinning region.

10. The bulk acoustic resonator according to claim 1, further comprising a substrate, wherein the acoustic reflection component is embedded into the substrate, or is arranged on a surface of the substrate.

11. The bulk acoustic resonator according to claim 10, wherein the acoustic reflection component is located on the surface of the substrate, and the first electrode protrudes upwards on the surface of the substrate, wherein the acoustic reflection component is located between a protruding upwards part of the first electrode and the surface of the substrate, and the piezoelectric layer directly covers the first electrode, to form the first gap between the piezoelectric layer and the second electrode connection part.

12. The bulk acoustic resonator according to claim 1, wherein in a direction from the first electrode to the second electrode, an upper surface of the second electrode connection part is not higher than an upper surface of a part of the second electrode within the effective resonance region.

13. The bulk acoustic resonator according to claim 12, wherein the upper surface of the second electrode connection part is flush with the upper surface of the part of the second electrode within the effective resonance region.

14. The bulk acoustic resonator according to claim 13, wherein the second electrode connection part is connected to the part of the second electrode within the effective resonance region through a recess part, a part of the recess part connected to the part of the second electrode within the effective resonance region directly contacts with the piezoelectric layer.

15. The bulk acoustic resonator according to claim 14, wherein the recess part is V-shaped or U-shaped.

16. The bulk acoustic resonator according to claim 12, wherein in a direction from the first electrode to the second electrode, the upper surface of the second electrode connection part is lower than the upper surface of the part of the second electrode within the effective resonance region, and the second electrode connection part is connected to the part of the second electrode within the effective resonance region through an inclined part.

17. The bulk acoustic resonator according to claim 16, wherein
the inclined part directly contacts with the piezoelectric layer; or
the part of the second electrode within the effective resonance region extends horizontally for a distance to connect to the inclined part, wherein the inclined part does not contact with the piezoelectric layer.

18. The bulk acoustic resonator according to claim 1, wherein a part of the second electrode other than the second electrode connection part extends away from the effective resonance region to form an extension part of the second electrode, a second gap is formed between the second electrode extension part and the piezoelectric layer, and in the direction from the first electrode to the second electrode, an upper surface of the second gap is not higher than an upper surface of a part of the piezoelectric layer within the effective resonance region.

19. The bulk acoustic resonator according to claim 18, wherein the first electrode further comprises a second thinning region, a thickness of the second thinning region is less than a thickness of a part of a first electrode within the effective resonance region, wherein the piezoelectric layer directly covers the second thinning region, to form the second gap between the piezoelectric layer and the second electrode extension part.

20. The bulk acoustic resonator according to claim 1, wherein the acoustic reflection component is a cavity or a Bragg reflector.

21. A resonator assembly, comprising a first resonator, an electrical component and a connection structure, wherein
the first resonator is the bulk acoustic resonator according to any one of claims 1 to 20; and
two ends of the connection structure are connected to a second electrode connection part in the first resonator and the electrical component, respectively.

22. The resonator assembly according to claim 21, wherein in the direction from the first electrode to the second electrode, an upper surface of the connection structure is not higher than an upper surface of a part of the second electrode within the effective resonance region in the first resonator.

23. The resonator assembly according to claim 22, wherein in the direction from the first electrode to the second electrode, the upper surface of the connection structure is flush with the upper surface of the part of the second electrode within the effective resonance region in the first resonator, and a third gap is formed between the connection structure and the piezoelectric layer.

24. The resonator assembly according to claim 22, wherein in the direction from the first electrode to the second electrode, the upper surface of the connection structure is lower than the upper surface of the part of the second electrode within the effective resonance region in the first resonator, and a third gap is formed between the connection structure and the piezoelectric layer, or the connection structure directly contacts with the piezoelectric layer.

25. The resonator assembly according to claim 21, wherein a side the second electrode connection part close to the connection structure comprises at least one concave-convex structure, and the connection structure is connected to at least one of the second electrode connection part in the first resonator and the electrical component through the at least one concave-convex structure.

26. The resonator assembly according to claim 21, wherein the electrical component comprises a bulk acoustic resonator, a capacitor, an inductor, or a pad.

27. The resonator assembly according to claim 21, wherein the second electrode of the first resonator is connected to the electrical component through the second electrode connection part, the connection structure, and a connection member, the piezoelectric layer is provided with a through hole, the connection member is arranged in the through hole and connected to the electrical component, in the direction from the first electrode to the second electrode, the connection member extends from the through hole to an upper surface of the piezoelectric layer.

28. The resonator assembly according to claim 27, wherein an end of the connection member arranged on the upper surface of the piezoelectric layer is lifted upwards to form a lifting part, and a fourth gap is formed between the lifting part and the piezoelectric layer.

29. A filter, comprising the bulk acoustic resonator according to any one of claims 1 to 20, or the resonator assembly according to any one of claims 21 to 28.

30. An electronic device, the bulk acoustic resonator according to any one of claims 1 to 20, or the resonator assembly according to any one of claims 21 to 28.
